(19) Europäisches Patentamt / European Patent Office / Office européen des brevets

(11) **EP 4 300 112 B1**

(12) **FASCICULE DE BREVET EUROPEEN**

(45) Date de publication et mention de la délivrance du brevet:
**13.11.2024 Bulletin 2024/46**

(21) Numéro de dépôt: **23180777.7**

(22) Date de dépôt: **21.06.2023**

(51) Classification Internationale des Brevets (IPC):
**G01R 31/54** *(2020.01)* **H02H 3/353** *(2006.01)*
**G01R 29/16** *(2006.01)*

(52) Classification Coopérative des Brevets (CPC):
**G01R 31/54; G01R 29/16**

(54) **DETECTION DE PERTE DE NEUTRE**

NEUTRALVERLUSTDETEKTION

DETECTION OF LOSS OF NEUTRAL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **28.06.2022 FR 2206489**

(43) Date de publication de la demande:
**03.01.2024 Bulletin 2024/01**

(73) Titulaire: **Sagemcom Energy & Telecom SAS**
**92270 Bois-Colombes (FR)**

(72) Inventeurs:
- **LHUILLIER, Pierre**
  **92500 RUEIL MALMAISON (FR)**
- **SAINT-LEGER, Sébastien**
  **92500 RUEIL MALMAISON (FR)**

(74) Mandataire: **Cabinet Boettcher et al**
**5, rue de Vienne**
**75008 Paris (FR)**

(56) Documents cités:
**EP-A1- 3 173 800    WO-A1-2015/179908**

**Description**

L'invention concerne le domaine des réseaux de distribution d'énergie électrique et des équipements qui sont connectés auxdits réseaux.

ARRIERE PLAN DE L'INVENTION

Un réseau de distribution électrique permet de transporter une énergie électrique d'une unité de production électrique vers une ou plusieurs installations électriques abonnées. Le transport de l'énergie électrique est généralement effectué en triphasé, le réseau électrique se composant alors de trois conducteurs de phase et d'un conducteur de neutre. Un réseau électrique est également typiquement équipé d'une pluralité de compteurs électrique qui permettent de mesurer la consommation d'énergie électrique des installations électriques abonnées.

Dans un réseau électrique triphasé, il est possible qu'une rupture de la connexion du neutre se produise en amont d'un ou plusieurs compteurs. Une telle rupture est à la responsabilité du fournisseur d'énergie en charge du réseau et peut notamment engendrer des problèmes importants au niveau des installation électriques abonnés. En effet, en fonction des impédances de charge des installations électriques abonnés (en aval du point de rupture du neutre), un déséquilibrage significatif des tensions de phase portées par les trois conducteurs de phase peut se produire. Il est donc possible que des tensions importantes apparaissent au niveau des installations électriques abonnées, qui peuvent éventuellement détruire lesdites installations.

Il est donc important de pouvoir détecter de manière fiable, simple et rapide une rupture soudaine de la connexion du neutre dans un réseau de distribution électrique triphasé. Cela permet de prendre rapidement des mesures préventives et/ou de protection pour les installations électriques abonnées.

Classiquement, la détection d'une rupture de connexion d'un neutre est basée sur la détection d'un déséquilibre anormal entre les tensions de phases du réseau de distribution et/ou d'une absence de courant circulant sur le conducteur de neutre. Néanmoins, cette méthode s'avère généralement peu fiable car elle ne permet pas de correctement identifier si le déséquilibre observé est lié à une rupture du neutre ou bien à une rupture d'une ou plusieurs phases. De plus, la détection de l'absence de courant à travers le conducteur de neutre nécessite d'utiliser des capteurs de courant positionné sur ledit conducteur de neutre ce qui a pour conséquences d'augmenter les coûts et de poser des problèmes d'implémentation physique et électrique.

Il est également connu, pour détecter une rupture de connexion d'un neutre, de mesurer les impédances de charge avales (des installations électriques abonnées) afin de déterminer le déséquilibre des tensions de phase attendu en cas de rupture de la connexion du neutre (et donc de le détecter lorsque ledit déséquilibre se produit effectivement). Cependant, l'efficacité et la fiabilité de cette méthode sont directement liées à la fiabilité des mesures des impédances de charge avales. Cela constitue un facteur limitant car la détermination du déséquilibre attendu entre les tensions de phase utilise typiquement une analyse théorique pour laquelle les impédances de charge avales sont considérées comme linéaires et constantes dans le temps (ce qui n'est pas nécessairement le cas dans la réalité). En outre, dans le cas où la rupture de neutre affecte plusieurs compteurs électriques ayant chacun des impédances de charge avales distinctes (non corrélées) et déséquilibrées, alors la méthode décrite précédemment ne permet plus de détecter la rupture de la connexion du neutre. En effet, pour un compteur donné l'impédance de charge avale mesurée ne considère que les installations électriques en aval dudit compteur. Or, le déséquilibre entre les tensions de phase est lui lié à l'impédance de charge avale équivalente issue de la combinaison de l'ensemble des impédances de charges avales de tous les compteurs affectés par la rupture de la connexion du neutre. L'impédance de charge équivalente n'étant pas mesurable, la méthode décrite précédemment n'est plus applicable dans ce cas de figure.

EP3173800A1 concerne un procédé de détection d'une absence de neutre dans un réseau polyphasé depuis un compteur raccordant une installation consommatrice au réseau de distribution, le procédé comprenant les étapes de:

- déterminer les tensions efficaces entre les phases en aval du compteur et un potentiel de référence du compteur,
- calculer un rapport entre la plus forte de ces tensions et la plus faible de ces tensions,
- lorsque ce rapport est supérieur à 1, émettre une alerte représentative d'une absence de neutre.

OBJET DE L'INVENTION

L'invention a pour objet de permettre de détecter, dans un réseau de distribution électrique, une rupture de connexion d'un neutre en amont d'un ou plusieurs compteurs électriques de manière rapide, simple et fiable.

RESUME DE L'INVENTION

En vue de la réalisation de cet objet, on propose un procédé de détection d'une rupture de connexion d'un neutre d'un réseau électrique triphasé, le procédé de détection étant mis en oeuvre au moins partiellement dans une unité de traitement d'un équipement électrique connecté au réseau électrique, et comprenant les étapes, répétées régulièrement, de :

- acquérir, à un temps T, une première tension de phase mesurée entre une première phase du réseau électrique triphasé et le neutre, une deuxième tension de phase mesurée entre une deuxième phase et le neutre, et une troisième tension de phase mesurée entre une troisième phase et le neutre, les première, deuxième et troisième tensions de phase étant mesurées par des capteurs de tension de l'équipement électrique ;
- évaluer une première grandeur représentative d'un rapport entre une tension de phase maximum et une tension de phase minimum parmi les première, deuxième et troisième tensions de phase ;
- si la première grandeur est supérieure à un seuil prédéterminé, alors :

  ◦ évaluer, à partir des première, deuxième et troisième tensions de phase, au moins une deuxième grandeur représentative d'un équilibrage courant desdites première, deuxième et troisième tensions de phase entre elles ;
  ◦ détecter une rupture de connexion du neutre au temps T lorsque la au moins une deuxième grandeur vérifie un critère de référence prédéterminé.

Le procédé de détection selon l'invention est donc particulièrement avantageux car il permet de détecter une rupture de la connexion d'un neutre dans un réseau de distribution (en amont d'un compteur électrique) à partir de la simple mesure des tensions de phases portées par les conducteurs de phase dudit réseau. Le procédé de détection est donc simple à mettre en oeuvre (car il ne requiert que des capteurs de tension) et peu coûteux.

En outre, le procédé de détection selon l'invention est également hautement fiable car, lorsqu'une suspicion de la rupture du neutre est établie (c'est-à-dire lorsque la première grandeur est supérieure au seuil prédéterminé) alors la deuxième grandeur est évaluée et permet de confirmer sans doute possible qu'une rupture de la connexion du neutre s'est bien produite.

Sachant que la deuxième grandeur est directement évaluée sur la base des tensions de phase (la deuxième grandeur est évaluée uniquement à partir des première, deuxième et troisième tensions de phase ; son évaluation ne nécessite donc pas l'acquisition de mesures supplémentaires), le procédé de détection selon l'invention peut détecter rapidement une rupture de la connexion du neutre.

On propose de plus un procédé de détection tel que précédemment décrit, dans lequel la au moins une deuxième grandeur comprend une deuxième grandeur qui est fonction d'une somme de produits deux à deux de valeurs efficaces des première, deuxième et troisième tensions de phase.

On propose de plus un procédé de détection tel que précédemment décrit, dans lequel ladite deuxième grandeur G2 est égale à :

$$G2 = \sqrt{\frac{1}{3}(V_{1eff}V_{2eff} + V_{2eff}V_{3eff} + V_{3eff}V_{1eff})},$$

où $V_{1eff}$, $V_{2eff}$ et $V_{3eff}$ sont respectivement une valeur efficace de la première tension de phase, une valeur efficace de la deuxième tension de phase et une valeur efficace de la troisième tension de phase,
le critère de référence prédéterminé étant que :

$$BorneInf \leq G2 \leq BorneSup.$$

On propose de plus un procédé de détection tel que précédemment décrit, comprenant en outre les étapes de :

- détecter si :

$$V_{1eff} = V_{nom} \quad \text{et} \quad V_{2eff} = V_{nom} \quad \text{et} \quad V_{3eff} = V_{nom},$$

où $V_{nom}$ une valeur efficace nominale de tension de phase du réseau électrique ;
- si cette condition est remplie, définir **BorneInf** et **BorneSup** de la manière suivante :

$$BorneInf = V_{nom}$$

et

$$BorneSup = \sqrt{\frac{2\sqrt{3}+1}{4}}\, V_{nom}\,.$$

On propose de plus un procédé de détection tel que précédemment décrit, dans lequel, si ladite condition n'est pas remplie, et si :

$$V_{1eff} = a_1 \cdot V_{nom} \quad \text{et} \quad V_{2eff} = a_2 \cdot V_{nom} \quad \text{et} \quad V_{3eff} = a_3 \cdot V_{nom},$$

où, $a_1$, $a_2$ et $a_3$ sont des coefficients réels tels que $a_1 \neq a_2 \neq a_3$, alors :

$$BorneInf = min(B1, B2, B3, B4, B5, B6)$$

et

$$BornSup = max(B1, B2, B3, B4, B5, B6),$$

où

$$B1 = \sqrt{\frac{\sqrt{(a_1^2+a_2^2+a_1 a_2)(a_1^2+a_3^2+a_1 a_3)}}{3}}\, V_{nom},$$

$$B2 = \sqrt{\frac{\sqrt{(a_2^2+a_3^2+a_2 a_3)(a_2^2+a_1^2+a_2 a_1)}}{3}}\, V_{nom},$$

$$B3 = \sqrt{\frac{\sqrt{(a_3^2+a_1^2+a_3 a_1)(a_3^2+a_2^2+a_3 a_2)}}{3}}\, V_{nom},$$

$$B4 = \sqrt{\frac{2\sqrt{(4a_1^2+a_2^2+a_3^2+2a_1 a_2+2a_1 a_3-a_2 a_3)(a_2^2+a_3^2+a_2 a_3)}+(a_2^2+a_3^2+a_2 a_3)}{12}}\, V_{nom},$$

$$B5 = \sqrt{\frac{2\sqrt{(4a_2^2+a_3^2+a_1^2+2a_2 a_3+2a_2 a_1-a_3 a_1)(a_3^2+a_1^2+a_3 a_1)}+(a_3^2+a_1^2+a_3 a_1)}{12}}\, V_{nom},$$

$$B6 = \sqrt{\frac{2\sqrt{(4a_3^2+a_1^2+a_2^2+2a_3 a_1+2a_3 a_2-a_1 a_2)(a_1^2+a_2^2+a_1 a_2)}+(a_1^2+a_2^2+a_1 a_2)}{12}}\, V_{nom}\,.$$

On propose de plus un procédé de détection tel que précédemment décrit, dans lequel les au moins une deuxième grandeur comprennent une deuxième grandeur qui est fonction d'une aire d'un triangle effectif formé par les premières, deuxième et troisième tensions de phase dans la représentation de Fresnel.

On propose de plus un procédé de détection tel que précédemment décrit, dans lequel l'aire du triangle effectif est déterminée en utilisant la formule : $A =$

$$\frac{1}{2}(V_{1eff}V_{2eff}\sin\varphi_{12} + V_{2eff}V_{3eff}\sin\varphi_{23} + V_{3eff}V_{1eff}\sin\varphi_{31})$$ , où A est la deuxième grandeur, $V_{1eff}$, $V_{2eff}$ et $V_{3eff}$ sont respectivement les valeurs efficaces des première, deuxième et troisième tensions de phase, et $\varphi_{12}$ est un premier déphasage entre la première tension de phase et la deuxième tension de phase, $\varphi23$ est un deuxième déphasage entre la deuxième tension de phase et la troisième tension de phase et $\varphi31$ est un troisième déphasage entre la troisième tension de phase et la première tension de phase, le critère de référence étant alors que la deuxième grandeur est telle que :

$$A_{ref} - \varepsilon_1 \le A \le A_{ref} + \varepsilon_1$$

où $A_{ref}$ est une aire d'un triangle de référence et $\varepsilon_1$ est une première incertitude de mesure prédéterminée.

On propose de plus un procédé de détection tel que précédemment décrit, dans lequel, si les première, deuxième et troisième tensions de phase sont parfaitement équilibrées entre elles, l'aire du triangle de référence prédéterminé est évaluée en utilisant la formule : $$A_{ref} = \frac{3\sqrt{3}}{4}V_{nom}$$ , où $A_{ref}$ est l'aire du triangle de référence et $V_{nom}$ est la valeur efficace nominale de tension de phase du réseau électrique.

On propose de plus un procédé de détection tel que précédemment décrit, dans lequel la au moins une deuxième grandeur comprend des deuxièmes grandeurs qui comportent une première tension composée $U_{12}$ représentative d'une différence entre la première tension de phase et la deuxième tension de phase, une deuxième tension composée $U_{23}$ représentative d'une différence entre la deuxième tension de phase et la troisième tension de phase et une troisième tension composée $U_{31}$ représentative d'une différence entre la troisième tension de phase et la première tension de phase, le critère de référence étant alors que :

$$\Phi_1 - \varepsilon_2 \le U_{12} \le \Phi_1 + \varepsilon_2$$

et

$$\Phi_2 - \varepsilon_2 \le U_{23} \le \Phi_2 + \varepsilon_2$$

et

$$\Phi_3 - \varepsilon_2 \le U_{31} \le \Phi_3 + \varepsilon_2,$$

où $\Phi_1$, $\Phi_2$ et $\Phi_3$ sont des valeurs de référence des premières, deuxième et troisième tensions composées mesurées en opération à un temps de référence $T_0$ précédent le temps T et $\varepsilon_2$ est une deuxième incertitude de mesure prédéterminée.

On propose de plus un procédé de détection tel que précédemment décrit, dans lequel les au moins une deuxième grandeur comprennent des deuxièmes grandeurs qui comportent un premier déphasage entre la première tension de phase et la deuxième tension de phase, un deuxième déphasage entre la deuxième tension de phase et la troisième tension de phase et un troisième déphasage entre la troisième tension de phase et la première tension de phase, le critère de référence prédéterminé étant alors que les premier, deuxième et troisième déphasages sont chacun non nuls et différents de 120 degrés.

On propose de plus un procédé de détection tel que précédemment décrit, comprenant en outre l'étape de détecter une rupture de connexion du neutre lorsqu'il a été détecté que la deuxième grandeur vérifie le critère de référence prédéterminé un nombre de fois prédéterminé, correspondant à des vérifications consécutives espacées deux à deux dans le temps d'une durée prédéterminée.

On propose de plus un procédé de détection tel que précédemment décrit, dans lequel, lorsqu'une rupture de connexion du neutre a été détectée, le procédé comprend en outre l'étape de générer un signal d'alarme pouvant être horodaté dans une mémoire de l'équipement électrique et/ou pouvant être transmis à un équipement externe audit équipement électrique.

On propose de plus un équipement électrique comprenant des capteurs de tension et une unité de traitement agencée pour mettre en oeuvre le procédé de détection tel que précédemment décrit.

On propose de plus un équipement électrique tel que précédemment décrit, l'équipement électrique étant un compteur électrique.

On propose de plus un programme d'ordinateur comprenant des instructions qui conduisent l'équipement électrique tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un réseau de distribution électrique triphasé ;
[Fig. 2] la figure 2 représente un diagramme de Fresnel des tensions de phase du réseau de distribution illustré à la figure 1 dans des conditions nominales ;
[Fig. 3] la figure 3 représente une architecture électronique des capteurs de tensions d'un compteur électrique du réseau de distribution illustré à la figure 1 ;
[Fig. 4] la figure 4 représente l'influence d'une rupture de la connexion d'un neutre sur les tensions de phase du réseau de distribution illustré à la figure 1 ;
[Fig. 5] la figure 5 représente l'influence d'une rupture de la connexion d'un neutre sur les tensions de phase du réseau de distribution illustré à la figure 1 dans la représentation de Fresnel ;
[Fig. 6] la figure 6 représente les étapes du procédé de détection d'une rupture de la connexion d'un neutre selon l'invention.

DESCRIPTION DETAILLEE DE L'INVENTION

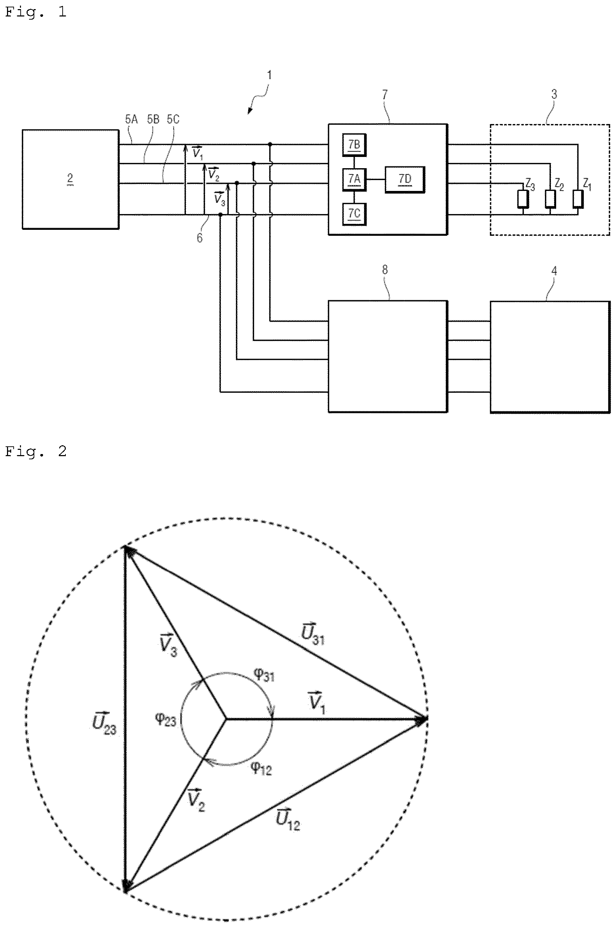

En référence à la figure 1, il est présenté un réseau de distribution électrique 1. Le réseau de distribution 1 permet de transporter une énergie électrique d'une unité de production électrique 2 vers une ou plusieurs installations électriques, ici une première installation électrique 3 et une deuxième installation électrique 4.

Le réseau de distribution 1 est un réseau électrique triphasé qui comporte un premier conducteur de phase 5A, un deuxième conducteur de phase 5B, un troisième conducteur de phase 5C et un conducteur de neutre 6. Pour simplifier la description, le terme « conducteur » sera par la suite omis pour parler simplement d'une première phase 5A, d'une deuxième phase 5B, d'une troisième phase 5C et d'un neutre 6.

Le réseau de distribution 1 porte une première tension de phase $V_1$ entre la première phase 5A et le neutre 6, une deuxième tension de phase $V_2$ entre la deuxième phase 5B et le neutre 6 et une troisième tension de phase $V_3$ entre la troisième phase 5C et le neutre 6. Les première, deuxième et troisième tensions de phase $V_1$, $V_2$, $V_3$ sont des tensions alternatives (sinusoïdales) présentant une fréquence de 50Hz.

En référence à la figure 2, il est représenté la première tension de phase $V_1$, la deuxième tension de phase $V_2$ et la troisième tension de phase $V_3$ dans la représentation de Fresnel lorsque le réseau de distribution 1 est en opération dans des conditions nominales.

La valeur efficace de la première tension de phase $V_{1eff}$, la valeur efficace de la deuxième tension de phase $V_{2eff}$ et la valeur efficace de la troisième tension de phase $V_{3eff}$ sont toutes égales à la valeur efficace nominale de tension de phase, notée $V_{nom}$, et qui est égale à 230V.

En outre, les première, deuxième et troisième tensions de phase $V_1$, $V_2$, $V_3$ sont chacune déphasées les unes par rapport aux autres. Ainsi, un premier déphasage $\varphi_{12}$ est présent entre la représentation vectorielle de la première tension de phase $V_1$ et celle de la deuxième tension de phase $V_2$, un deuxième déphasage $\varphi_{23}$ est présent entre la représentation vectorielle de la deuxième tension de phase $V_2$ et celle de la troisième tension de phase $V_3$ et un troisième déphasage $\varphi_{31}$ est présent entre la représentation vectorielle de la troisième tension de phase $V_3$ et celle de la première tension de phase $V_1$. Le premier déphasage $\varphi_{12}$, le deuxième déphasage $\varphi_{23}$ et le troisième déphasage $\varphi_{31}$ sont tous égaux à 120°.

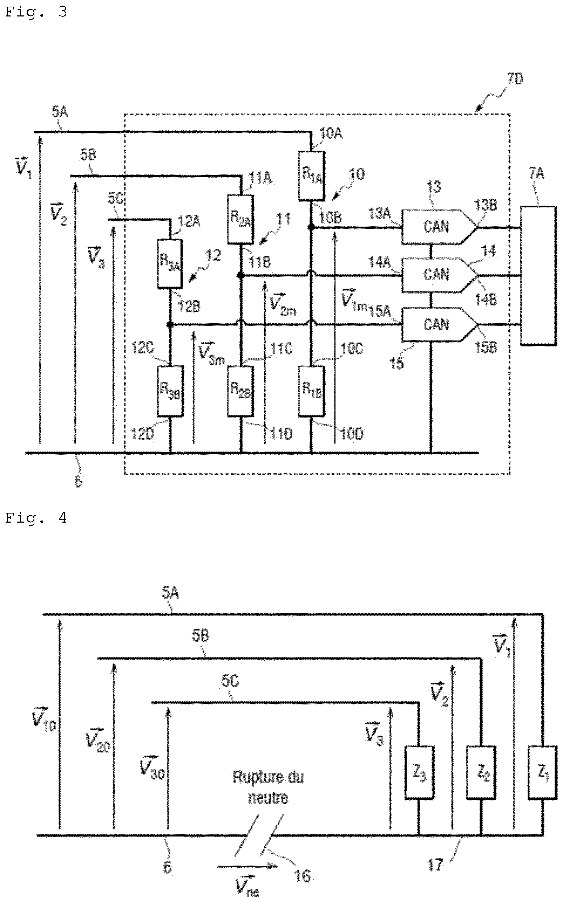

La figure 3 met également en évidence une première tension composée $U_{12}$ qui correspond à une différence entre la première tension de phase $V_1$ et la deuxième tension de phase $V_2$, une deuxième tension composée $U_{23}$ qui correspond à une différence entre la deuxième tension de phase $V_2$ et la troisième tension de phase $V_3$ et une troisième tension composée $U_{31}$ qui correspond à une différence entre la troisième tension de phase $V_3$ et la première tension de phase $V_1$.

A nouveau en référence à la figure 1, un premier compteur 7 est connecté au réseau de distribution 1 entre l'unité de production 2 et la première installation 3. Le premier compteur 7 est destiné à mesurer une consommation d'énergie électrique fournie à la première installation 3 via le réseau de distribution 1. La première installation 3 est ici représenté par une première impédance électrique $Z_1$ connectée entre la première phase 5A et le neutre 6, par une deuxième impédance électrique $Z_2$ connectée entre la deuxième phase 5B et le neutre 6 et par une troisième impédance électrique connectée entre la troisième phase 5C et le neutre 6. Ainsi, en opération dans des conditions nominales, la première impédance $Z_1$ présente la première tension de phase $V_1$ à ses bornes, la deuxième impédance $Z_2$ présente la deuxième tension de phase $V_2$ à ses bornes et la troisième impédance $Z_3$ présente la troisième tension de phase $V_3$ à ses bornes.

Un deuxième compteur 8 est également connecté au réseau de distribution entre l'unité de production 2 et la deuxième installation 4. Le deuxième compteur 8 est destiné à mesurer une consommation d'énergie électrique fournie à la deuxième installation 4 via le réseau de distribution 1.

Le premier compteur 7 et le deuxième compteur 8 sont des compteurs triphasés.

Il est maintenant décrit l'architecture du premier compteur 7.

Le premier compteur 7 comporte tout d'abord une unité de traitement 7A qui comprend au moins un composant de traitement qui peut être un processeur de signal numérique ou DSP (en anglais, *Digital Signal Processor*), un processeur, un microcontrôleur, un FPGA (en anglais, *Field Programmable Gate Array*) ou encore un ASIC (en anglais, *Application-Specific Integrated Circuit*) .

Le premier compteur 7 comporte en outre une mémoire 7B connectée à l'unité de traitement 7A ou intégrée dans l'unité de traitement 7A. La mémoire 7B forme un support d'enregistrement lisible par ordinateur, sur lequel est enregistré au moins un programme d'ordinateur comprenant des instructions permettant de mettre en oeuvre au moins partiellement le procédé de détection qui va être décrit.

Le premier compteur 7 comporte en outre un module de communication 7C connecté à l'unité de traitement 7A et qui est agencé pour transmettre des données selon la technologie CPL (pour Courant Porteur de Ligne). Il est à noter que d'autres standards de communication pourraient être utilisés, par exemple, la technologie radio cellulaire.

Le premier compteur 7 comporte en outre des capteurs de tension 7D connectés à l'unité de traitement 7A et qui sont agencés pour mesurer la première tension de phase $V_1$, la deuxième tension de phase $V_2$ et la troisième tension de phase $V_3$ du réseau de distribution 1.

En référence à la figure 3, il est décrit plus précisément les capteurs de tensions 7D du premier compteur 7.

Les capteurs de tensions 7D comportent une première branche 10, une deuxième branche 11 et une troisième branche 12.

Les capteurs de tensions comportent en outre un premier convertisseur analogique-numérique 13, un deuxième convertisseur analogique-numérique 14 et une troisième convertisseur analogique numérique 15. Dans la suite, pour simplifier la description, il sera question du premier CAN 13, du deuxième CAN 14 et du troisième CAN 15.

La première branche 10 comporte deux premières résistances $R_{1A}$, $R_{1B}$. Le première résistance $R_{1A}$ comporte une première borne 10A connectée à la première phase 5A et une deuxième borne 10B connectée à une entrée 13A du premier CAN 13. Le première résistance $R_{1B}$ comporte une première borne 10C connectée à l'entrée 13A du premier CAN 13 et une deuxième borne 10D connectée au neutre 6. Les deux premières résistances $R_{1A}$, $R_{1B}$ forment ainsi un pont diviseur de tension entre la première phase 5A et le neutre 6. Une première tension de mesure $V_{1m}$ est donc présente entre l'entrée 13A du premier CAN 13 et le neutre 6. La première tension de mesure $V_{1m}$ est l'image de la première tension de phase V1 et est conforme à la plage de tension d'entrée du premier CAN 13.

La deuxième branche 11 comporte deux deuxièmes résistances $R_{2A}$, $R_{2B}$. Le deuxième résistance $R_{2A}$ comporte une première borne 11A connectée à la deuxième phase 5B et une deuxième borne 11B connectée à une entrée 14A du deuxième CAN 14. Le deuxième résistance $R_{2B}$ comporte une première borne 11C connectée à l'entrée 14A du deuxième CAN 14 et une deuxième borne 11D connectée au neutre 6. Les deux deuxièmes résistances $R_{2A}$, $R_{2B}$ forment ainsi un pont diviseur de tension entre la deuxième phase 5B et le neutre 6. Une deuxième tension de mesure $V_{2m}$ est donc présente entre l'entrée 14A du deuxième CAN 14 et le neutre 6. La deuxième tension de mesure $V_{2m}$ est l'image de la deuxième tension de phase $V_2$ et est conforme à la plage de tension d'entrée du deuxième CAN 14 .

La troisième branche 12 comporte deux troisièmes résistances $R_{3A}$, $R_{3B}$. Le troisième résistance $R_{3A}$ comporte une première borne 12A connectée à la troisième phase 5C et une deuxième borne 12B connectée à une entrée 15A du troisième CAN 15. La troisième résistance $R_{3B}$ comporte une première borne 12C connectée à l'entrée 15A du troisième CAN 15 et une deuxième borne 12D connectée au neutre 6. Les deux troisièmes résistances $R_{3A}$, $R_{3B}$ forment ainsi un pont diviseur de tension entre la troisième phase 5C et le neutre 6. Une troisième tension de mesure $V_{3m}$ est donc présente entre l'entrée 15A du troisième CAN 15 et le neutre 6. La troisième tension de mesure $V_{3m}$ est l'image de la troisième tension de phase $V_3$ et est conforme à la plage de tension d'entrée du troisième CAN 15.

Les ponts diviseurs de tension de chacune des première, deuxième et troisième branches 10, 11, 12 permettent respectivement de réduire les amplitudes des première, deuxième et troisième tensions de phase $V_1$, $V_2$, $V_3$ pour les rendre compatibles avec la plage de mesure du premier CAN 13, du deuxième CAN 14 et du troisième CAN 15.

Le premier CAN 13 comporte une sortie 13B connectée à l'unité de traitement 7A. Le premier CAN 13 va donc produire des premiers échantillons de mesure représentatifs de la première tension de phase $V_1$ et les fournir à l'unité de traitement 7A.

Le deuxième CAN 14 comporte une sortie 14B connectée à l'unité de traitement 7A. Le deuxième CAN 14 va donc produire des deuxièmes échantillons de mesure représentatifs de la deuxième tension de phase $V_2$ et les fournir à l'unité de traitement 7A.

Le troisième CAN 15 comporte une sortie 15B connectée à l'unité de traitement 7A. Le troisième CAN 15 va donc produire des troisièmes échantillons de mesure représentatifs de la troisième tension de phase $V_3$ et les fournir à l'unité de traitement 7A.

Il est prévu que le premier CAN 13, le deuxième CAN 14 et le troisième CAN 15 présentent tous des caractéristiques adéquates (nombre bits, fréquence d'échantillonnage) pour correctement convertir la première tension de mesure $V_{1m}$, la deuxième tension de mesure $V_{2m}$ et la troisième tension de mesure $V_{3m}$, respectivement. Ici, le premier CAN 13, le deuxième CAN 14 et le troisième CAN 15 présentent chacun un nombre de bits supérieur ou égale à 12 bits et une fréquence d'échantillonnage d'au moins 2kSps (en anglais, *kilo Samples per second* - millier d'échantillons par seconde).

Il est maintenant décrit l'influence d'une rupture de la connexion du neutre 6 dans le réseau de distribution 1.

En référence à la figure 4, il est supposé qu'une rupture de la connexion du neutre 6 se produit dans le réseau de distribution 1 en un point de rupture 16 situé en amont du premier compteur 7. Par « en amont », il est entendu du côté de l'unité de production 2 et par en « en aval », il est entendu du côté de la première installation 3.

Lorsque la rupture de la connexion du neutre 6 se produit un noeud 17 devient flottant.

La première tension de phase $V_1$ en aval du point de rupture 16 s'équilibre alors spontanément en fonction de la première impédance $Z_1$ de la première installation 3. Ainsi, la première impédance $Z_1$ présente la première tension de phase $V_1$ à ses bornes qui est la tension portée par la première phase 5A en aval du point du rupture 16. La première tension de phase $V_1$ s'exprime en fonction d'une première tension de phase nominale $V_{10}$ (qui est la tension portée par la première phase 5A en amont du point de rupture 16) et une différence de potentiel $V_{ne}$ induite par la rupture de la connexion du neutre 6 :

$$V_1 = V_{10} - V_{ne}.$$

De même, la deuxième tension de phase $V_2$ en aval du point de rupture 16 s'équilibre spontanément en fonction de la deuxième impédance $Z_2$ de la première installation 3. Ainsi, la deuxième impédance $Z_2$ présente la deuxième tension de phase $V_2$ à ses bornes qui est la tension portée par la deuxième phase 5B en aval du point du rupture 16. La première tension de phase $V_2$ s'exprime en fonction d'une deuxième tension de phase nominale $V_{20}$ (qui est la tension portée par la deuxième phase 5B en amont du point de rupture 16) et la différence de potentiel $V_{ne}$ :

$$V_2 = V_{20} - V_{ne}.$$

De même, la troisième tension de phase $V_3$ en aval du point de rupture 16 s'équilibre spontanément en fonction de la troisième impédance $Z_3$ de la première installation 3. Ainsi, la troisième impédance $Z_3$ présente la troisième tension de phase $V_3$ à ses bornes qui est la tension portée par la troisième phase 5C en aval du point du rupture 16. La troisième tension de phase $V_3$ s'exprime en fonction d'une troisième tension de phase nominale $V_{30}$ (qui est la tension portée par la troisième phase 5C en amont du point de rupture 16) et la différence de potentiel $V_{ne}$ :

$$V_3 = V_{30} - V_{ne}.$$

Il est à noter que lorsque le neutre 6 est correctement connecté, $V_1 = V_{10}$, $V_2 = V_{20}$ et $V_3 = V_{30}$.

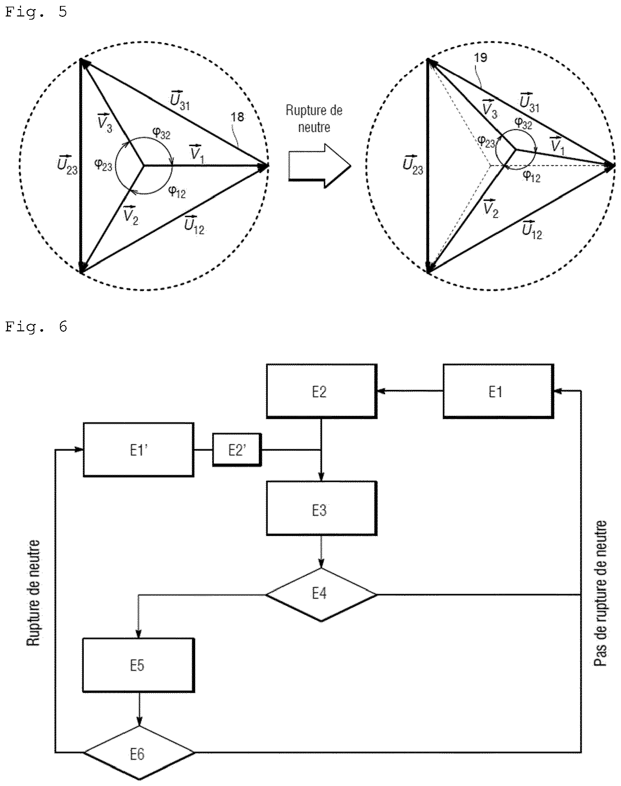

En référence à la figure 5, il est représenté dans la représentation de Fresnel, l'influence de la rupture de connexion du neutre 6.

Il est intéressant de remarquer que la rupture de la connexion du neutre 6 induit un nouvel équilibrage de la première tension de phase $V_1$, de la deuxième tension de phase $V_2$ et de la troisième tension de phase $V_3$ entre elles. Mis à part dans le cas particulier où les première, deuxième et troisième impédances électriques $Z_1$, $Z_2$, $Z_3$ sont parfaitement équilibrées sur les première, deuxième et troisième phases 5A, 5B, 5C, le nouvel équilibrage sera différent de l'équilibrage initial (lorsque le neutre 6 était correctement connecté).

Le nouvel équilibrage implique une variation de la valeur efficace de la première tension de phase $V_{1eff}$, de la valeur efficace de la deuxième tension de phase $V_{2eff}$ et de la valeur efficace de la troisième tension de phase $V_{3eff}$ qui ne sont alors plus nécessairement égales à la valeur efficace nominale de tension de phase $V_{nom}$.

Le nouvel équilibrage implique également une variation du premier déphasage $\varphi_{12}$, du deuxième déphasage $\varphi_{23}$ et du troisième déphasage $\varphi_{31}$ qui ne sont alors plus nécessairement tous égaux à 120°.

En revanche, le nouvel équilibrage conserve la première tension composée $U_{12}$, la deuxième tension composée $U_{23}$ et la troisième tension composée $U_{31}$.

En référence à la figure 6, il est maintenant décrit les étapes du procédé de détection de rupture de connexion d'un neutre selon l'invention.

Le procédé de détection selon l'invention est mis en oeuvre dans l'unité de traitement 7A du premier compteur 7. Plus particulièrement, le procédé de détection selon l'invention est mis en oeuvre par l'unité de traitement 7A du premier compteur en continu. Les étapes dudit procédé de détection sont donc répétées régulièrement dans le temps.

Le procédé démarre à un temps T par l'acquisition de la première tension de phase $V_1$ entre la première phase 5A et le neutre 6, de la deuxième tension de phase $V_2$ entre la deuxième phase 5B et le neutre 6 et de la troisième tension de phase $V_3$ entre la troisième phase 5C et le neutre 6 (étape E1).

Plus précisément l'unité de traitement 7A acquiert les premiers échantillons de mesure représentatifs de la première tension de phase $V_1$, les deuxièmes échantillons de mesure représentatifs de la deuxième tension de phase $V_2$ et les troisièmes échantillons de mesure représentatifs de la troisième tension de phase $V_3$. Les premiers échantillons de mesure, les deuxièmes échantillons de mesure et les troisièmes échantillons de mesure étant transmis à l'unité de traitement 7A par les capteurs de tensions 7D.

L'unité de traitement 7A va, à partir des premiers échantillons de mesure, des deuxièmes échantillons de mesure et des troisièmes échantillons de mesure, respectivement déterminer (éventuellement en appliquant des paramètres de calibration) une valeur efficace de la première tension de phase $V_{1eff}$, une valeur efficace de la deuxième tension de phase $V_{2eff}$ et une valeur efficace de la troisième tension de phase $V_{3eff}$. Les valeurs efficaces $V_{1eff}$, $V_{2eff}$ et $V_{3eff}$ sont ici respectivement déterminées par l'unité de traitement 7A chaque seconde sur la base des premiers, deuxièmes et troisièmes échantillons de mesure acquis à la seconde précédente. Les valeurs efficaces $V_{1eff}$, $V_{2eff}$ et $V_{3eff}$ pourraient également être déterminées sur une seconde glissante ou sur tout autre fenêtre temporelle pertinente.

Par la suite, l'unité de traitement 7A va définir et/ou mettre à jour un critère de référence prédéterminée (étape E2). Le critère de référence prédéterminé va être décrit par la suite.

Il est à noter que l'étape E2 est optionnelle. En effet, la définition du critère de référence prédéterminé pourrait être réalisée une seule fois lors d'une phase d'installation du premier compteur 7 dans le réseau de distribution 1 (le critère de de référence prédéterminé étant enregistré dans la mémoire 7B). La définition et/ou la mise à jour du critère de référence prédéterminé pourrait être également réalisée pendant une phase de maintenance du premier compteur 7.

L'unité de traitement 7A va ensuite évaluer une première grandeur représentative d'un rapport entre une tension de phase maximum et une tension de phase minimum parmi les première, deuxième et troisième tensions de phase $V_1$, $V_2$, $V_3$ (étape E3). Plus précisément, la première grandeur est ici un nombre M qui est déterminé en utilisant la formule suivante :

$$M = \frac{\max\left(V_{1eff}, V_{2eff}, V_{3eff}\right)}{\min\left(V_{1eff}, V_{2eff}, V_{3eff}\right)}.$$

L'évaluation de la première grandeur M va permettre de vérifier s'il existe un déséquilibre ou non entre les première, deuxième et troisième tensions de phase $V_1$, $V_2$, $V_3$.

Dans ce but, la première grandeur M va être comparée à un seuil prédéterminé (étape E4). Le seuil prédéterminé est ici égal à 1.2 pour tenir compte notamment des dispersions normales des première, deuxième et troisième tensions de phase $V_1$, $V_2$, $V_3$ (intrinsèque dans le réseau de distribution 1). Si la première grandeur M est supérieure au seuil prédéterminé alors il existe un déséquilibre significatif entre les première, deuxième et troisième tensions de phase $V_1$, $V_2$, $V_3$ et cela constitue un premier indicateur permettant d'émettre une suspicion de rupture de la connexion du neutre 6 dans le réseau de distribution 1 en amont du premier compteur 7.

Néanmoins, le simple fait que la première grandeur M soit supérieure au seuil prédéterminé n'est pas suffisant pour s'assurer qu'une rupture de connexion du neutre 6 s'est effectivement produite. Notamment, une simple rupture de la connexion d'une phase (parmi les première, deuxième et troisième phase 5A, 5B, 5C) pourrait également mener à la même observation (la première grandeur M est supérieure au seuil prédéterminé). Il est donc nécessaire de confirmer la suspicion de rupture de la connexion du neutre 6 en déterminant un indicateur qui est caractéristique d'une rupture de la connexion d'un neutre dans un réseau électrique triphasé.

Il est à noter que si la première grandeur M est inférieure au seuil prédéterminé alors le procédé de détection selon l'invention détermine qu'il n'y a pas de rupture de la connexion du neutre 6 et revient donc à l'étape E1.

Si la première grandeur est supérieure au seuil prédéterminé, alors l'unité de traitement 7A va évaluer, à partir des première, deuxième et troisième tensions de phase $V_1$, $V_2$, $V_3$, au moins une deuxième grandeur représentative d'un équilibrage courant desdites première, deuxième et troisième tensions de phase entre elles (étape E5). En effet, comme il a été montré à la figure 5, la rupture de la connexion d'un neutre va entraîner un nouvel équilibrage des première, deuxième et troisième tensions de phase $V_1$, $V_2$, $V_3$ entre elles.

L'unité de traitement 7A va alors détecter si la au moins une deuxième grandeur vérifie le critère de référence prédéterminé.

A partir de là, plusieurs méthodes sont possibles et en particulier plusieurs deuxièmes grandeurs différentes ainsi que plusieurs critères de référence prédéterminés peuvent être définis pour confirmer effectivement qu'une rupture de la connexion du neutre 6 s'est produite.

Selon un premier mode de réalisation, la au moins une deuxième grandeur comprend une deuxième grandeur G2 qui est fonction d'une somme des produits deux à deux des première, deuxième et troisième tensions de phase $V_1$, $V_2$, $V_3$. Plus précisément, la deuxième grandeur G2 est fonction d'une somme de produits deux à deux de valeurs efficaces des première, deuxième et troisième tensions de phase $V_{1eff}$, $V_{2eff}$, $V_{3eff}$.

L'approche proposée ici repose sur le fait que lorsqu'une suspicion de la rupture de la connexion du neutre est établie, les première, deuxième et troisième tensions de phase $V_1$, $V_2$, $V_3$ vont s'équilibrer selon le nouvel équilibrage qui n'est pas complètement aléatoire.

Si une des valeurs efficaces d'une tension de phase parmi les valeurs efficaces des première, deuxième et troisième tensions de phase $V_{1eff}$, $V_{2eff}$, $V_{3eff}$ diminue fortement, alors que les deux autres valeurs efficaces restent constantes, cela ne traduit pas une rupture de la connexion du neutre 6. Par exemple, si la valeur efficace $V_{1eff}$ diminue fortement alors que les valeurs efficaces $V_{2eff}$ et $V_{3eff}$ restent constantes, il sera plutôt question d'un creux de tension sur la première phase 5A ou encore d'une rupture de la connexion de ladite première phase 5A. Cependant, si une des valeurs efficaces d'une tension de phase parmi les valeurs efficaces des première, deuxième et troisième tensions de phase $V_{1eff}$, $V_{2eff}$, $V_{3eff}$ diminue fortement et que en même temps l'une des deux autres valeurs efficaces augmente (ou même que les deux valeurs efficaces augmentent) alors il est fortement probable que cela soit lié à une rupture de la connexion du neutre 6. Par exemple, si la valeur efficace $V_{1eff}$ diminue fortement et que les valeurs efficaces $V_{2eff}$ et $V_{3eff}$ augmentent simultanément alors il est fortement probable que cela soit lié à une rupture de la connexion du neutre 6.

De même, si une des valeurs efficaces d'une tension de phase parmi les valeurs efficaces des première, deuxième et troisième tensions de phase $V_{1eff}$, $V_{1eff}$, $V_{3eff}$ augmente fortement alors que les deux autres valeurs efficaces restent constantes, cela ne traduit pas une rupture de la connexion du neutre 6.

Afin de confirmer la suspicion de rupture de la connexion du neutre 6, l'unité de traitement 7A va calculer la deuxième grandeur G2 en utilisant la formule suivante :

$$G2 = \sqrt{\frac{1}{3}(V_{1eff}V_{2eff} + V_{2eff}V_{3eff} + V_{3eff}V_{1eff})},$$

où $V_{1eff}$, $V_{2eff}$ et $V_{3eff}$ sont respectivement la valeur efficace de la première tension de phase, la valeur efficace de la deuxième tension de phase et la valeur efficace de la troisième tension de phase.

La deuxième grandeur G2 est proposée car elle est bornée lorsqu'une rupture de la connexion du neutre 6 se produit. Dans le premier mode de réalisation, le critère de référence prédéterminé qui est défini par l'unité de traitement 7A est donc de vérifier que la deuxième grandeur G2 est bornée entre une borne inférieure ***BornInf*** et une borne supérieure ***BornSup*** :

$$BorneInf \leq G2 \leq BorneSup.$$

Afin de correctement définir ***BornInf*** et ***BornSup*** le procédé de détection comprend en outre les étapes de :

- détecter si les première, deuxième et troisième tensions de phase $V_1$, $V_2$, $V_3$ sont parfaitement équilibrées entre elles, c'est-à-dire si la valeur efficace de la première tension de phase $V_{1eff}$, la valeur efficace de la deuxième tension de phase $V_{2eff}$ et la valeur efficace de la troisième tension de phase $V_{3eff}$ sont toutes égales ou non à la valeur efficace nominale de tension de phase $V_{nom}$ du réseau de distribution 1 :

$$V_{1eff} = V_{nom} \quad \text{et} \quad V_{2eff} = V_{nom} \quad \text{et} \quad V_{3eff} = V_{nom},$$

- si cette condition est remplie, définir ***BorneInf*** et ***BorneSup*** de la manière suivante :

$$BorneInf = V_{nom}$$

et

$$BorneSup = \sqrt{\frac{2\sqrt{3}+1}{4}}\, V_{nom}.$$

Autrement, si ladite condition n'est pas remplie, et donc si :
$V_{1eff} = a_1 \cdot V_{nom}$ et $V_{2eff} = a_2 \cdot V_{nom}$ et $V_{3eff} = a_3 \cdot V_{nom}$, où $a_1$, $a_2$ et $a_3$ sont des coefficients réels tels que $a_1 \neq a_2 \# a_3$ et $V_{nom}$ est ladite valeur efficace nominale, alors :

$$BorneInf = min(B1, B2, B3, B4, B5, B6)$$

et

$$BornSup = max(B1, B2, B3, B4, B5, B6),$$

où

$$B1 = \sqrt{\frac{\sqrt{(a_1^2+a_2^2+a_1 a_2)(a_1^2+a_3^2+a_1 a_3)}}{3}}\, V_{nom},$$

$$B2 = \sqrt{\frac{\sqrt{(a_2^2+a_3^2+a_2 a_3)(a_2^2+a_1^2+a_2 a_1)}}{3}}\, V_{nom},$$

$$B3 = \sqrt{\frac{\sqrt{(a_3^2+a_1^2+a_3 a_1)(a_3^2+a_2^2+a_3 a_2)}}{3}}\, V_{nom},$$

$$B4 = \sqrt{\frac{2\sqrt{(4a_1^2+a_2^2+a_3^2+2a_1 a_2+2a_1 a_3-a_2 a_3)(a_2^2+a_3^2+a_2 a_3)}+(a_2^2+a_3^2+a_2 a_3)}{12}}\, V_{nom},$$

$$B5 = \sqrt{\frac{2\sqrt{(4a_2^2+a_3^2+a_1^2+2a_2 a_3+2a_2 a_1-a_3 a_1)(a_3^2+a_1^2+a_3 a_1)}+(a_3^2+a_1^2+a_3 a_1)}{12}}\, V_{nom},$$

$$B6 = \sqrt{\frac{2\sqrt{(4a_3^2+a_1^2+a_2^2+2a_3 a_1+2a_3 a_2-a_1 a_2)(a_1^2+a_2^2+a_1 a_2)}+(a_1^2+a_2^2+a_1 a_2)}{12}}\, V_{nom}.$$

L'annexe 1 propose une démonstration mathématique permettant de déterminer l'expression de *BornInf* et *BornSup.*

Si la deuxième grandeur G2 est bornée entre la borne inférieure *BornInf* et la borne supérieure *BornSup* (c'est-à-dire si la deuxième grandeur G2 vérifie le critère de référence prédéterminé) alors le procédé de détection selon l'invention détecte une rupture de connexion du neutre au temps T en amont du premier compteur 7.

Dans le premier mode de réalisation, il est également possible de détecter une rupture de la connexion du neutre 6 lorsqu'une phase parmi les première, deuxième et troisième phases 5A, 5B, 5C est déconnectée. Il est ici considéré que la troisième phase 5C est déconnectée. Si une rupture de la connexion du neutre 6 se produit alors on se retrouve avec une relation caractéristique entre la valeur efficace de la première tension de phase $V_{1eff}$ et la valeur efficace de la deuxième tension de phase $V_{2eff}$.

Si les première, deuxième et troisième tensions de phase $V_1$, $V_2$, $V_3$ sont parfaitement équilibrées entre elles, c'est-à-dire si : $V_{1eff} = V_{nom}$ et $V_{2eff} = V_{nom}$ et $V_{3eff} = V_{nom}$, alors la relation caractéristique est la suivante :

$$V_{1eff} + V_{2eff} = \sqrt{3}V_{nom}$$

, où $V_{nom}$ est la valeur efficace nominale de tension de phase.

Si les première, deuxième et troisième tensions de phase $V_1$, $V_2$, $V_3$ ne sont pas parfaitement équilibrées entre elles, c'est-à-dire si : $V_{1eff} = a_1 \cdot V_{nom}$ et $V_{2eff} = a_2 \cdot V_{nom}$ et $V_{3eff} = a_3 \cdot V_{nom}$, $(a_1 \neq a_2 \neq a_3)$ alors la relation caractéristique est la suivante : $$V_{1eff} + V_{2eff} = V_{nom}\sqrt{a_1^2 + a_2^2 + a_1 a_2}$$ , où $V_{nom}$ est la valeur efficace nominale de tension de phase.

Un algorithme plus complet et plus détaillé permettant de mettre en oeuvre le procédé de détection selon le premier mode de réalisation de l'invention est présenté en Annexe 2.

Selon un deuxième mode de réalisation, le procédé de détection comprend l'étape d'évaluer la au moins une deuxième grandeur qui comprend une deuxième grandeur A qui est fonction d'une aire d'un triangle effectif 19 formé par les première, deuxième et troisième tensions de phase $V_1$, $V_2$, $V_3$ dans la représentation de Fresnel.

Le triangle effectif 19 présente une première arête constituée par la première tension composée $U_{12}$, une deuxième arête constituée par la deuxième tension composée $U_{23}$ et une troisième arête constituée par la troisième tension composée $U_{31}$.

La deuxième grandeur A est déterminée par l'unité de traitement 7A en utilisant la formule : $A = \frac{1}{2}(V_{1eff}V_{2eff}\sin\varphi_{12} + V_{2eff}V_{3eff}\sin\varphi_{23} + V_{3eff}V_{1eff}\sin\varphi_{31})$ , où A est la deuxième grandeur (qui est l'aire du triangle effectif 19), $V_{1eff}$, $V_{2eff}$ et $V_{3eff}$ sont respectivement les valeurs efficaces des première, deuxième et troisième tensions de phase, et $\varphi_{12}$ est le premier déphasage, $\varphi_{23}$ est le deuxième déphasage et $\varphi_{31}$ est le troisième déphasage. Le premier déphasage $\varphi_{12}$, le deuxième déphasage $\varphi_{23}$ et le troisième déphasage $\varphi_{31}$ sont déterminés par l'unité de traitement 7A à partir des première, deuxième et troisième tensions de phase $V_1$, $V_2$, $V_3$ via une méthode de « zero-crossing » (détection de passage par zéro) et un filtrage adéquat.

Le critère de référence étant alors que la deuxième grandeur A est telle que :
$A_{ref} - \varepsilon_1 \leq A \leq A_{ref} + \varepsilon_1$, où $A_{ref}$ est une aire d'un triangle de référence 18 prédéterminée et $\varepsilon_1$ est une première incertitude de mesure prédéterminée (typiquement, +/- 1% ou +/- 2%).

En référence à la figure 5, l'aire du triangle de référence 18 $A_{ref}$ est en fait l'air du triangle formé par les première, deuxième et troisième tensions de phase $V_1$, $V_2$, $V_3$ dans la représentation de Fresnel dans des conditions nominales (c'est-à-dire lorsqu'il n'y a pas de rupture de la connexion du neutre 6).

Il est en effet intéressant de remarquer que l'air du triangle de référence 18 et l'aire du triangle effectif 19 sont similaires dans le cas d'une rupture de la connexion du neutre 6. Ainsi, en comparant la deuxième grandeur A (l'aire du triangle effectif 19) avec l'aire du triangle de référence 18 prédéterminée $A_{ref}$, il est possible de déterminer effectivement si une rupture de connexion du neutre 6 s'est produite.

Afin de correctement définir l'aire du triangle de référence 18 $A_{ref}$, le procédé de détection comprend en outre les étapes de :

- détecter si les première, deuxième et troisième tensions de phase $V_1$, $V_2$, $V_3$ sont parfaitement équilibrées entre elles, c'est-à-dire si la valeur efficace de la première tension de phase $V_{1eff}$, la valeur efficace de la deuxième tension de phase $V_{2eff}$ et la valeur efficace de la troisième tension de phase $V_{3eff}$ sont toutes égales ou non à la valeur efficace nominale de tension de phase $V_{nom}$ du réseau de distribution 1 :

$$V_{1eff} = V_{nom} \quad \text{et} \quad V_{2eff} = V_{nom} \quad \text{et} \quad V_{3eff} = V_{nom},$$

- si cette condition est remplie, alors l'aire du triangle de référence 18 est évaluée en utilisant la formule : $A_{ref} = \frac{3\sqrt{3}}{4}V_{nom}$ , où $V_{nom}$ est la valeur efficace nominale de tension de phase.

Autrement, si ladite condition n'est pas remplie, et donc si :

$$V_{1eff} = a_1 \cdot V_{nom} \text{ et } V_{2eff} = a_2 \cdot V_{nom} \text{ et } V_{3eff} = a_3 \cdot V_{nom},$$

où $a_1$, $a_2$ et $a_3$ sont des coefficients réels tels que $a_1 \neq a_2 \neq a_3$ et $V_{nom}$ est ladite valeur efficace nominale, alors l'aire du triangle de référence 18 est évaluée en utilisant la formule : $A_{ref} = (a_1 a_2 + a_2 a_3 + a_3 a_1)\frac{\sqrt{3}}{4}V_{nom}$ , où $V_{nom}$ est ladite valeur efficace nominale de tension de phase.

Si la deuxième grandeur A vérifie le critère de référence prédéterminé alors le procédé de détection selon l'invention détecte une rupture de connexion du neutre au temps T en amont du premier compteur 7.

Selon un troisième mode de réalisation de l'invention, la au moins une deuxième grandeur comprend des deuxièmes grandeurs qui comportent la première tension composée $U_{12}$, la deuxième tension composée $U_{23}$ et la troisième tension composée $U_{31}$.

En référence à la figure 5, en cas de rupture de la connexion du neutre 6, la première tension composée $U_{12}$, la deuxième tension composée $U_{23}$ et la troisième tension composée $U_{31}$ restent constantes.

Le critère de référence vérifié par l'unité de traitement 7A est donc de vérifier si :

$$\Phi_1 - \varepsilon_2 \leq U_{12} \leq \Phi_1 + \varepsilon_2$$

et

$$\Phi_2 - \varepsilon_2 \leq U_{23} \leq \Phi_2 + \varepsilon_2$$

et

$$\Phi_3 - \varepsilon_2 \leq U_{31} \leq \Phi_3 + \varepsilon_2,$$

où $\Phi_1$, $\Phi_2$ et $\Phi_3$ sont respectivement des valeurs de référence des premières, deuxième et troisième tensions composées $U_{12}$, $U_{23}$, $U_{31}$ mesurées en opération à un temps de référence $T_0$ précédent le temps T et $\varepsilon_2$ est une deuxième incertitude de mesure prédéterminée (typiquement, +/- 1% ou +/- 2%).

Si les deuxièmes grandeur $U_{12}$, $U_{23}$ et $U_{31}$ vérifient le critère de référence prédéterminé alors le procédé de détection selon l'invention détecte une rupture de connexion du neutre au temps T en amont du premier compteur 7.

Selon un quatrième mode de réalisation de l'invention, le procédé de détection comprend l'étape d'évaluer la au moins une deuxième grandeur qui comprend des deuxièmes grandeurs qui comportent le premier déphasage $\varphi_{12}$, le deuxième déphasage $\varphi_{23}$ et le troisième déphasage $\varphi_{31}$.

En référence à la figure 5, il est intéressant de remarquer que le premier déphasage $\varphi_{12}$, le deuxième déphasage $\varphi_{23}$ et le troisième déphasage $\varphi_{31}$ ne sont plus égaux à 120° lorsqu'une rupture de la connexion du neutre 6 se produit.

Le critère de référence défini par l'unité de traitement 7A est alors de vérifier si les premier, deuxième et troisième déphasages $\varphi_{12}$, $\varphi_{23}$, $\varphi_{31}$ sont chacun non nuls et différents de 120 degrés.

Si les premier, deuxième et troisième déphasages $\varphi_{12}$, $\varphi_{23}$, $\varphi_{31}$ vérifient le critère de référence prédéterminé alors le procédé de détection selon l'invention détecte une rupture de connexion du neutre au temps T en amont du premier compteur 7.

Dans les quatre modes de réalisation de l'invention présentés ci-dessus, si la ou les deuxièmes grandeurs ne vérifient pas le critère de référence prédéterminée alors le procédé de détection passe à l'étape E1' qui est similaire à l'étape E1 et éventuellement passe par une étape E2' qui est similaire à l'étape E2.

Dans les quatre modes de réalisation de l'invention présentés ci-dessus, une marge d'incertitude adéquate, liée notamment à la précision des capteurs de tension 7D du premier compteur 7, est à prendre en compte. Typiquement, la marge d'incertitude est de l'ordre de +/- 1% ou +/- 2%.

Dans les quatre modes de réalisation de l'invention présentés ci-dessus, les expressions utilisées pour la définition du critère de référence prédéterminé (***BornInf***, ***BornSup,*** $A_{ref}$, $\Phi_1$, $\Phi_2$ et $\Phi_3$) pourraient être déterminées par l'unité de traitement 7A en moyennant plusieurs calculs successifs afin d'atténuer des phénomènes parasites (tels qu'une surtension transitoire de type onde de choc ou micro-coupure) qui risqueraient de diminuer la fiabilité du procédé de détection selon l'invention. L'utilisation d'une technique de moyennage est tout à fait faisable en prenant comme hypothèse que le réseau de distribution 1 est stable pendant une durée donnée.

Quel que soit le mode de réalisation considéré, le procédé de détection selon l'invention est mis en oeuvre par l'unité de traitement 7A du premier compteur en continu. Les étapes dudit procédé de détection sont donc répétées régulièrement dans le temps.

Avantageusement et quel que soit le mode de réalisation considéré, le procédé de détection selon l'invention peut comprendre en outre l'étape de détecter une rupture de connexion du neutre 6 lorsqu'il a été détecté que la deuxième grandeur vérifie le critère de référence prédéterminé un nombre de fois prédéterminé (par exemple 10 fois), correspondant à des vérifications consécutives (c'est-à-dire à des mises en oeuvre du procédé de détection consécutives) espacées deux à deux dans le temps d'une durée prédéterminée (par exemple 1 seconde). Cela permet d'augmenter la fiabilité du procédé de détection selon l'invention.

Optionnellement, lorsqu'une rupture de connexion du neutre a été effectivement détectée, le procédé de détection peut comprendre en outre l'étape de générer un signal d'alarme pouvant être horodaté dans la mémoire 7B du premier compteur 7 et/ou pouvant être transmis (via le module de communication 7C) à un équipement externe audit premier compteur 7, par exemple un Système d'Information du réseau de distribution 1.

Optionnellement, le signal d'alarme peut être l'affichage d'un message particulier sur un afficheur local du premier compteur 7 et/ou le signal d'alarme peut être l'allumage d'un indicateur lumineux localisé sur ledit premier compteur 7 et/ou l'allumage d'un signal sonore émis par un haut-parleur dudit premier compteur 7.

Idéalement, tous les compteurs électriques du réseau de distribution 1 sont similaires et sont agencés pour mettre en oeuvre le procédé de détection selon l'invention. Ainsi, l'ensemble du réseau de distribution 1 est correctement surveillé.

Optionnellement, lorsqu'une rupture de connexion du neutre a été effectivement détectée et que le déséquilibre entre les première, deuxième et troisième tension de phase est considéré comme trop important, alors le procédé de détection peut comprendre en outre l'étape, si ledit procédé de détection est mis en oeuvre dans un compteur particulier comprenant un organe de coupure, d'ouvrir ledit organe de coupure pour protéger une ou des installations électriques en aval dudit compteur particulier.

Bien entendu, l'invention n'est pas limitée aux modes de réalisation décrits mais englobe toute variante entrant dans le champ de l'invention telle que définie par les revendications.

Il est tout à fait possible de combiner librement les différents modes de réalisation présentés précédemment. Ainsi, l'unité de traitement 7A du premier compteur 7 peut déterminer plusieurs deuxièmes grandeurs, par exemple la deuxième grandeur G2 (présentée dans le premier mode de réalisation) et la deuxième grandeur A (présentée dans le deuxième mode de réalisation). Cela pourrait permettre d'augmenter la fiabilité du procédé de détection selon l'invention.

Il a été présenté les capteurs de tension 7D du premier compteur 7 comprenant un premier CAN 13, un deuxième CAN 14 et un troisième CAN 15 mais il est tout à fait possible que les capteurs de tension 7D comprennent un unique CAN comprenant trois entrées distinctes permettant chacune d'acquérir respectivement la première tension de phase, la deuxième tension de phase et la troisième tension de phase.

**Annexe 1** : **Démonstration formelle des relations proposées pour le premier mode de réalisation**

L'hypothèse pour la présente démonstration est que les première, deuxième et troisième tensions de phase $V_1$, $V_2$, $V_3$ sont parfaitement équilibrées c'est-à-dire que les valeurs efficaces $V_{1eff}$, $V_{2eff}$, $V_{3eff}$ sont toutes égales à la valeur efficace nominale de tension de phase $V_{nom}$. Cela n'est pas nécessairement exact en pratique, mais peut être utilisé en première approche.

Il est à noter que des tensions dans la démonstration sont sous forme de vecteur et qu'il s'agit dans l'ensemble de la démonstration de valeurs efficaces complexes.

En référence à la figure 4, une fois qu'une rupture de la connexion du neutre s'est produite, alors il est possible d'écrire :

$$\overrightarrow{V_{10}} - \overrightarrow{V_1} = \overrightarrow{V_{ne}}$$

$$\overrightarrow{V_{20}} - \overrightarrow{V_2} = \overrightarrow{V_{ne}}$$

$$\overrightarrow{V_{30}} - \overrightarrow{V_3} = \overrightarrow{V_{ne}}$$

$$\overrightarrow{I_1} + \overrightarrow{I_2} + \overrightarrow{I_3} = 0$$

$I_1$, $I_2$, $I=$ sont les courants électriques circulant respectivement à travers la première phase 5A, la deuxième phase 5B et la troisième phase 5C.

$$\frac{\overrightarrow{V_{10}}}{Z_1} + \frac{\overrightarrow{V_{20}}}{Z_2} + \frac{\overrightarrow{V_{30}}}{Z_3} = \overrightarrow{V_{ne}}\left(\frac{1}{Z_1} + \frac{1}{Z_2} + \frac{1}{Z_3}\right)$$

En utilisant une première admittance $Y_1$, une deuxième admittance $Y_2$ et une troisième admittance $Y_3$ ($Y_1$=1/$Z_1$, $Y_2$=1/$Z_2$, $Y_3$=1/$Z_3$), on a :

$$\overrightarrow{V_{10}}Y_1 + \overrightarrow{V_{20}}Y_2 + \overrightarrow{V_{30}}Y_3 = \overrightarrow{V_{ne}}(Y_1 + Y_2 + Y_3)$$

On remplace $\overrightarrow{V_{ne}}$ : (1)

$$\overrightarrow{V_{10}}Y_1 + \overrightarrow{V_{20}}Y_2 + \overrightarrow{V_{30}}Y_3 = \overrightarrow{(V_{10}} - \overrightarrow{V_1})(Y_1 + Y_2 + Y_3)$$

Calcul de $V_1$

Sachant que :

$$V_{20} = V_{10}\left(-\frac{1}{2} - j\frac{\sqrt{3}}{2}\right)$$

$$V_{30} = V_{10}\left(-\frac{1}{2} + j\frac{\sqrt{3}}{2}\right)$$

A partir de la relation (1) on a :

$$V_{10}\left(Y_1 + \left(-\frac{1}{2} - j\frac{\sqrt{3}}{2}\right)Y_2 + \left(-\frac{1}{2} + j\frac{\sqrt{3}}{2}\right)Y_3\right) = (V_{10} - V_1)(Y_1 + Y_2 + Y_3)$$

$$V_{10}\left[\left(Y_1 - \frac{1}{2}Y_2 - \frac{1}{2}Y_3 - Y_1 - Y_2 - Y_3\right) + j\frac{\sqrt{3}}{2}(Y_3 - Y_2)\right] = -V_1(Y_1 + Y_2 + Y_3)$$

$$V_1 = V_{10}\left[\frac{\left(\frac{3}{2}Y_2 + \frac{3}{2}Y_3\right)}{(Y_1 + Y_2 + Y_3)} + j\frac{\sqrt{3}}{2}\frac{(Y_2 - Y_3)}{(Y_1 + Y_2 + Y_3)}\right]$$

En appliquant le module on a : (2)

$$V_1 = V_{10}\sqrt{\left(\frac{\frac{3}{2}(Y_2 + Y_3)}{(Y_1 + Y_2 + Y_3)}\right)^2 + \left(\frac{\sqrt{3}}{2}\frac{(Y_2 - Y_3)}{(Y_1 + Y_2 + Y_3)}\right)^2}$$

Calcul de $V_2$

A partir de la relation (1) on a :

$$V_{10} \left( Y_1 + \left( -\frac{1}{2} - j\frac{\sqrt{3}}{2} \right) Y_2 + \left( -\frac{1}{2} + j\frac{\sqrt{3}}{2} \right) Y_3 \right) = (V_{20} - V_2)(Y_1 + Y_2 + Y_3)$$

Sachant que :

$$V_{20} = V_{10} \left( -\frac{1}{2} - j\frac{\sqrt{3}}{2} \right)$$

Il vient que :

$$V_{10} \left[ \left( Y_1 - \frac{1}{2}Y_2 - \frac{1}{2}Y_3 + \frac{1}{2}Y_1 + \frac{1}{2}Y_2 + \frac{1}{2}Y_3 \right) + j\frac{\sqrt{3}}{2}(Y_3 - Y_2 + Y_1 + Y_2 + Y_3) \right]$$
$$= -V_2(Y_1 + Y_2 + Y_3)$$

$$V_2 = V_{10} \left( \frac{\left( -\frac{3}{2}Y_1 \right)}{(Y_1 + Y_2 + Y_3)} - j\frac{\sqrt{3}}{2}\frac{(2 \times Y_3 + Y_1)}{(Y_1 + Y_2 + Y_3)} \right)$$

En appliquant le module on a : (3)

$$V_2 = V_{10} \sqrt{ \left( -\frac{\frac{3}{2}Y_1}{(Y_1 + Y_2 + Y_3)} \right)^2 + \left( -\frac{\sqrt{3}}{2}\frac{(2 \times Y_3 + Y_1)}{(Y_1 + Y_2 + Y_3)} \right)^2 }$$

Calcul de $V_3$

A partir de la relation (1) on a :

$$V_{10} \left( Y_1 + \left( -\frac{1}{2} - j\frac{\sqrt{3}}{2} \right) Y_2 + \left( -\frac{1}{2} + j\frac{\sqrt{3}}{2} \right) Y_3 \right) = (V_{30} - V_3)(Y_1 + Y_2 + Y_3)$$

Sachant que :

$$V_{30} = V_{10} \left( -\frac{1}{2} + j\frac{\sqrt{3}}{2} \right)$$

Il vient que :

$$V_{10}\left[\left(Y_1 - \frac{1}{2}Y_2 - \frac{1}{2}Y_3 + \frac{1}{2}Y_1 + \frac{1}{2}Y_2 + \frac{1}{2}Y_3\right) + j\frac{\sqrt{3}}{2}(Y_3 - Y_2 - Y_1 - Y_2 - Y_3)\right]$$

$$= -V_2(Y_1 + Y_2 + Y_3)$$

$$V_3 = V_{10}\left(\frac{\left(-\frac{3}{2}Y_1\right)}{(Y_1 + Y_2 + Y_3)} + j\frac{\sqrt{3}}{2}\frac{(2 \times Y_2 + Y_1)}{(Y_1 + Y_2 + Y_3)}\right)$$

En appliquant le module on a : (4)

$$\boldsymbol{V_3} = \boldsymbol{V_{10}}\sqrt{\left(-\frac{\frac{3}{2}\boldsymbol{Y_1}}{(\boldsymbol{Y_1} + \boldsymbol{Y_2} + \boldsymbol{Y_3})}\right)^2 + \left(\frac{\sqrt{3}}{2}\frac{(2 \times \boldsymbol{Y_2} + \boldsymbol{Y_1})}{(\boldsymbol{Y_1} + \boldsymbol{Y_2} + \boldsymbol{Y_3})}\right)^2}$$

En utilisant les relation (2), (3) et (4) et en posant $V_{10} = V_{nom}$, nous avons :

$$V_1 V_2 + V_1 V_3 + V_2 V_3 = V_{nom}^2\, f(Y_1, Y_2, Y_3)$$

Avec :

$$f(Y_1, Y_2, Y_3) =$$

$$\sqrt{\left(\left(\frac{\frac{3}{2}(Y_2+Y_3)}{(Y_1+Y_2+Y_3)}\right)^2 + \left(\frac{\sqrt{3}}{2}\frac{(Y_2-Y_3)}{(Y_1+Y_2+Y_3)}\right)^2\right)\left(\left(\frac{\frac{3}{2}Y_1}{(Y_1+Y_2+Y_3)}\right)^2 + \left(\frac{\sqrt{3}}{2}\frac{(2\times Y_3+Y_1)}{(Y_1+Y_2+Y_3)}\right)^2\right)}$$

$$+ \sqrt{\left(\left(\frac{\frac{3}{2}(Y_2+Y_3)}{(Y_1+Y_2+Y_3)}\right)^2 + \left(\frac{\sqrt{3}}{2}\frac{(Y_2-Y_3)}{(Y_1+Y_2+Y_3)}\right)^2\right)\left(\left(-\frac{\frac{3}{2}Y_1}{(Y_1+Y_2+Y_3)}\right)^2 + \left(\frac{\sqrt{3}}{2}\frac{(2\times Y_2+Y_1)}{(Y_1+Y_2+Y_3)}\right)^2\right)}$$

$$+ \sqrt{\left(\left(\frac{\frac{3}{2}Y_1}{(Y_1+Y_2+Y_3)}\right)^2 + \left(\frac{\sqrt{3}}{2}\frac{(2\times Y_3+Y_1)}{(Y_1+Y_2+Y_3)}\right)^2\right)\left(\left(-\frac{\frac{3}{2}Y_1}{(Y_1+Y_2+Y_3)}\right)^2 + \left(\frac{\sqrt{3}}{2}\frac{(2\times Y_2+Y_1)}{(Y_1+Y_2+Y_3)}\right)^2\right)}$$

$$f(Y_1, Y_2, Y_3)$$

$$= \frac{1}{4(Y_1 + Y_2 + Y_3)^2}\left(\sqrt{(9(Y_2 + Y_3)^2 + 3(Y_3 - Y_2)^2)(9Y_1^2 + 3(Y_1 + 2Y_3)^2)}\right.$$

$$+ \sqrt{(9(Y_2 + Y_3)^2 + 3(Y_3 - Y_2)^2)(9Y_1^2 + 3(Y_1 + 2Y_2)^2)}$$

$$\left.+ \sqrt{(9Y_1^2 + 3(Y_1 + 2Y_3)^2)(9Y_1^2 + 3(Y_1 + 2Y_2)^2)}\right)$$

$$f(Y_1, Y_2, Y_3) = \frac{3}{(Y_1 + Y_2 + Y_3)^2}\left(\sqrt{(Y_2^2 + Y_2 Y_3 + Y_3^2)(Y_1^2 + Y_1 Y_3 + Y_3^2)}\right.$$

$$+\sqrt{(Y_2^2 + Y_2 Y_3 + Y_3^2)(Y_1^2 + Y_1 Y_2 + Y_2^2)}$$

$$\left.+\sqrt{(Y_1^2 + Y_1 Y_3 + Y_3^2)(Y_1^2 + Y_1 Y_2 + Y_2^2)}\right)$$

En étudiant les cas limites :
Cas 1 : $Y_1 = Y_2 = Y_3 = Y$ :

$$f(Y_1, Y_2, Y_3) = \frac{3}{9Y^2}\left(\sqrt{9Y^4} + \sqrt{9Y^4} + \sqrt{9Y^4}\right) = \frac{3}{9Y^2}\,9Y^2 = 3$$

Sachant que :

$$V_1 V_2 + V_1 V_3 + V_2 V_3 = V_{nom}^2\, f(Y_1, Y_2, Y_3)$$

Il vient que (le cas limite ici étudié constituant la borne inférieure) - $V_i$ et $V_j$ étant respectivement les tensions de phase des ième phase et jème phase :

$$\sum_{i \neq j} V_i V_j \geq 3\, V_{nom}^2$$

D'où :

$$\mathbf{V_{nom}} \leq \sqrt{\frac{\sum_{i \neq j} \boldsymbol{V_i V_j}}{\mathbf{3}}}$$

Cas 2 : $Y_1 = Y_2 = Y$ » $Y_3 = y$ :

$$f(Y_1, Y_2, Y_3) = \frac{3}{(2Y)^2}\left(\sqrt{(Y^2)(Y^2)} + \sqrt{(Y^2)(3Y^2)} + \sqrt{(Y^2)(3Y^2)}\right) = \frac{3(2\sqrt{3} + 1)}{4}$$

Sachant que :

$$V_1 V_2 + V_1 V_3 + V_2 V_3 = V_{nom}^2\, f(Y_1, Y_2, Y_3)$$

Il vient que (le cas limite ici étudié constituant la borne supérieure) :

$$\sum_{i \neq j} \boldsymbol{V_i V_j} \leq V_{nom}^2 \times \frac{\mathbf{3(2\sqrt{3} + 1)}}{\mathbf{4}}$$

D'où :

$$\sqrt{\frac{\sum_{i \neq j} V_i V_j}{3}} \leq \sqrt{\frac{2\sqrt{3}+1}{4}} \, V_{nom}$$

Nous avons bien démontré par études des cas limites que la somme des $V_iV_j$ restait bornée de façon très précises entre $V_{nom}$ et $1.056V_{nom}$ lors d'une rupture de connexion du neutre :

$$BorneInf \leq \sqrt{\frac{\sum_{i \neq j} V_i V_j}{3}} \leq BorneSup$$

$$BorneInf = V_{nom}$$

$$BorneSup = \sqrt{\frac{2\sqrt{3}+1}{4}} \, V_{nom} \; (= 1.056 \, V_{nom})$$

La formule proposée peut ensuite être généralisée, par le même procédé de calcul, pour tenir compte de conditions initiales pour lesquelles le réseau de distribution ne présentent pas de tensions de phase parfaitement équilibrées, cela en posant :

$$V_{1eff} = a_1 \cdot V_{nom} \quad \text{et} \quad V_{2eff} = a_2 \cdot V_{nom} \quad \text{et} \quad V_{3eff} = a_3 \cdot V_{nom},$$

où, $a_1$, $a_2$ et $a_3$ sont des coefficients réels tels que $a_1 \neq a_2 \neq a_3$.

Le fait est qu'en considérant l'effet des déséquilibres initiaux entre les tensions de phases provenant du réseau de distribution, les cas d'études asymptotiques à considérer (qui nous permettent d'obtenir une limite bornée du résultat attendu en cas de rupture de connexion du neutre) passent de 2 à 6, par perte de symétrie

Les 6 bornes sont données par :

$$B1 = \sqrt{\frac{\sqrt{(a_1^2+a_2^2+a_1a_2)(a_1^2+a_3^2+a_1a_3)}}{3}} \, V_{nom},$$

$$B2 = \sqrt{\frac{\sqrt{(a_2^2+a_3^2+a_2a_3)(a_2^2+a_1^2+a_2a_1)}}{3}} \, V_{nom},$$

$$B3 = \sqrt{\frac{\sqrt{(a_3^2+a_1^2+a_3a_1)(a_3^2+a_2^2+a_3a_2)}}{3}} \, V_{nom},$$

$$B4 = \sqrt{\frac{2\sqrt{(4a_1^2+a_2^2+a_3^2+2a_1a_2+2a_1a_3-a_2a_3)(a_2^2+a_3^2+a_2a_3)}+(a_2^2+a_3^2+a_2a_3)}{12}} \, V_{nom},$$

$$B5 = \sqrt{\frac{2\sqrt{(4a_2^2+a_3^2+a_1^2+2a_2a_3+2a_2a_1-a_3a_1)(a_3^2+a_1^2+a_3a_1)}+(a_3^2+a_1^2+a_3a_1)}{12}} \, V_{nom},$$

$$B6 = \sqrt{\frac{2\sqrt{(4a_3^2+a_1^2+a_2^2+2a_3a_1+2a_3a_2-a_1a_2)(a_1^2+a_2^2+a_1a_2)}+(a_1^2+a_2^2+a_1a_2)}{12}} \, V_{nom} \cdot$$

Et finalement :

$$BorneInf \leq \sqrt{\frac{\sum_{i\neq j} V_i V_j}{3}} \leq BorneSup$$

Avec :

$$BorneInf = min(B1, B2, B3, B4, B5, B6)$$

et

$$BornSup = max(B1, B2, B3, B4, B5, B6).$$

**Annexe 2 : Algorithme proposé pour le premier mode de réalisation**

```
// init
Un = 230
U[]=[230;230;230]
```

```
PhaseConnectStatus[] = [UNKNOWN; UNKNOWN; UNKNOWN]
NeutraConnectStatus = UNKNOWN
// param
Vmin = 60
Tol = 10%
N = 2
AlphaThreshold = 20%
DevThresholdLow = 10%
DevThresholdHigh = 20%
MarginLow = 0.5%
MarginHigh = 0.5%
MarginLow_bis = 2%
MarginHigh_bis = 2%
MarginAdd = 5%
Loop every second
    For i = 1 to 3
        cnt_unknwn = 0
        If (V[i] < Vmin)
            PhaseConnectStatus[i] = UNKNOWN
            cnt_unknwn ++
        Else
            PhaseConnectStatus[i] = CONNECTED
        End If
    End For
    For i = 1 to 3
        If V[i] < (1-Tol).Un
            Vtmp = U[i]
        Elsif V[i] > (1+Tol).Un
            Vtmp = U[i]
        Else
            Vtmp = V[i]
        End If
```

```
                U[i] = Vtmp/N + (N-1).U[i]/N
                a[i] = U[i]/Un
                Dev[i] = V[i]/U[i]
        End For
        If (cnt_unknwn >= 2)
                For i = 1 to 3
                        If (PhaseConnectStatus[i] = UNKNOWN)
                                PhaseConnectStatus[i] = DISCONNECTED
                        End If
                End For
        End If
        If (cnt_unknwn < 2)
                Alpha = Max(V[])/MIN(V[])
                If (((Alpha-1) > AlphaThreshold) AND (((1-
MIN(Dev[])) > DevThresholdLow) OR ((MAX(Dev[])-1) >
DevThresholdHigh)))
                        Vref = 0
                        For i = 1 to 3
                                j = i+1 %3
                                k = i+2 %3
                                Vref = Vref + V[i].V[j]/3
                                Factor1[i]                     =
SQRT((a[i]²+a[j]²+a[i].a[j]).(a[i]²+a[k]²+a[i].a[k]))
                                Factor2[i]                     =
(2.SQRT((4.a[i]²+a[j]²+a[k]²+2.a[i].a[j]+2.a[i].a[k]-
a[j].a[k]).(a[j]²+a[k]²+a[j].a[k]))+(a[j]²+a[k]²+a[j].a[k])
)/4
                        End For
                        Vref = SQRT(Vref)
                        Ulim1[i] = Un.SQRT(Factor1[i]/3)
                        Ulim2[i] = Un.SQRT(Factor2[i]/3)
                        If (NeutralConnectStatus = DISCONNECTED)
```

```
                MarginL = MarginLow + MarginAdd
                MarginH = MarginHigh + MarginAdd
            Else
                MarginL = MarginLow
                MarginH = MarginHigh
            End If
            If            ((Vref            >            (1-
MarginL).MIN(MIN(Ulim1[]),MIN(Ulim2[])))    AND    (Vref    <
(1+MarginH).MAX(MAX(Ulim1[]),MAX(Ulim2[])))))
                NeutralConnectStatus = DISCONNECTED
                For i = 1 to 3
                    If    (PhaseConnectStatus[i]    =
UNKNOWN)
                        PhaseConnectStatus[i]    =
CONNECTED
                    End If
                End For
            Else
                NeutralConnectStatus = CONNECTED
                For i = 1 to 3
                    If    (PhaseConnectStatus[i]    =
UNKNOWN)
                        PhaseConnectStatus[i]    =
DISCONNECTED
                        NeutralConnectStatus = UNKNOWN
                    End If
                End For
            End If
        End If
        If (NeutralConnectStatus = UNKNOWN)
            Vref_bis = 0
            For i = 1 to 3
```

```
                If (PhaseConnectStatus[i] = CONNECTED)
                        Vref_bis = Vref_bis + V[i]
                End If
        End For
        Vref_bis = Vref_bis/2
        For i = 1 to 3
                a_bis[i] = 0
                If (PhaseConnectStatus[i] = CONNECTED)
                        a_bis[i] = a[i]
                End If
        End For
        Factor_bis = 0
        For i = 1 to 3
                j = i+1 %3
                Factor_bis  =  Factor_bis  +  a_bis[i]² +
a_bis[i].a_bis[j]
        End For
        Ulim_bis = Un.SQRT(Factor_bis)/2
        If (NeutralConnectStatus = DISCONNECTED)
                MarginL_bis = MarginLow_bis + MarginAdd
                MarginH_bis = MarginHigh_bis + MarginAdd
        Else
                MarginL = MarginLow
                MarginH = MarginHigh
        End If
        If ((Vref_bis > (1-MarginL_bis).Ulim_bis) AND
(Vref_bis < (1+MarginH_bis).Ulim_bis))
                NeutralConnectStatus = DISCONNECTED
        Else
                NeutralConnectStatus = CONNECTED
        End If
    End If
```

```
End If

End Loop
```

**Revendications**

1.  Procédé de détection d'une rupture de connexion d'un neutre (6) d'un réseau électrique triphasé, le procédé de détection étant mis en oeuvre au moins partiellement dans une unité de traitement (7A) d'un équipement électrique (7) connecté au réseau électrique (1), et comprenant les étapes, répétées régulièrement, de :

    - acquérir, à un temps T, une première tension de phase ($V_1$) mesurée entre une première phase (5A) du réseau électrique triphasé et le neutre (6), une deuxième tension de phase ($V_2$) mesurée entre une deuxième phase (5B) et le neutre (6), et une troisième tension de phase ($V_3$) mesurée entre une troisième phase (5C) et le neutre (6), les première, deuxième et troisième tensions de phase étant mesurées par des capteurs de tension (7D) de l'équipement électrique (7) ;
    - évaluer une première grandeur représentative d'un rapport entre une tension de phase maximum et une tension de phase minimum parmi les première, deuxième et troisième tensions de phase ;

    le procédé étant **caractérisé en ce qu'**il comprend:

    - si la première grandeur est supérieure à un seuil prédéterminé, alors :

        ◦ évaluer, à partir des première, deuxième et troisième tensions de phase, au moins une deuxième grandeur représentative d'un équilibrage courant desdites première, deuxième et troisième tensions de phase entre elles ;
        ◦ détecter une rupture de connexion du neutre (6) au temps T lorsque la au moins une deuxième grandeur vérifie un critère de référence prédéterminé.

2.  Procédé de détection selon la revendication 1, dans lequel la au moins une deuxième grandeur comprend une deuxième grandeur qui est fonction d'une somme de produits deux à deux de valeurs efficaces des première, deuxième et troisième tensions de phase.

3.  Procédé de détection selon la revendication 2, dans lequel ladite deuxième grandeur $G2$ est égale à :

$$G2 = \sqrt{\frac{1}{3}(V_{1eff}V_{2eff} + V_{2eff}V_{3eff} + V_{3eff}V_{1eff})},$$

où $V_{1eff}$, $V_{2eff}$ et $V_{3eff}$ sont respectivement une valeur efficace de la première tension de phase ($V_1$), une valeur efficace de la deuxième tension de phase ($V_2$) et une valeur efficace de la troisième tension de phase ($V_3$), le critère de référence prédéterminé étant que :

$$BorneInf \leq G2 \leq BorneSup.$$

4.  Procédé de détection selon la revendication 3, comprenant en outre les étapes de :

    - détecter si :

$$V_{1eff} = V_{nom} \quad \text{et} \quad V_{2eff} = V_{nom} \quad \text{et} \quad V_{3eff} = V_{nom},$$

où $V_{nom}$ une valeur efficace nominale de tension de phase du réseau électrique ;

    - si cette condition est remplie, définir ***BorneInf*** et ***BorneSup*** de la manière suivante :

$$BorneInf = V_{nom}$$

et

$$BorneSup = \sqrt{\frac{2\sqrt{3}+1}{4}}\, V_{nom}\,.$$

**5.** Procédé de détection selon la revendication 4, dans lequel, si ladite condition n'est pas remplie, et si :

$$V_{1eff} = a_1 \cdot V_{nom} \quad \text{et} \quad V_{2eff} = a_2 \cdot V_{nom} \quad \text{et} \quad V_{3eff} = a_3 \cdot V_{nom},$$

où, $a_1$, $a_2$ et $a_3$ sont des coefficients réels tels que $a_1 \neq a_2 \neq a_3$, alors :

$$BorneInf = min(B1, B2, B3, B4, B5, B6)$$

et

$$BornSup = max(B1, B2, B3, B4, B5, B6),$$

où

$$B1 = \sqrt{\frac{\sqrt{(a_1^2+a_2^2+a_1 a_2)(a_1^2+a_3^2+a_1 a_3)}}{3}}\, V_{nom},$$

$$B2 = \sqrt{\frac{\sqrt{(a_2^2+a_3^2+a_2 a_3)(a_2^2+a_1^2+a_2 a_1)}}{3}}\, V_{nom},$$

$$B3 = \sqrt{\frac{\sqrt{(a_3^2+a_1^2+a_3 a_1)(a_3^2+a_2^2+a_3 a_2)}}{3}}\, V_{nom},$$

$$B4 = \sqrt{\frac{2\sqrt{(4a_1^2+a_2^2+a_3^2+2a_1 a_2+2a_1 a_3-a_2 a_3)(a_2^2+a_3^2+a_2 a_3)}+(a_2^2+a_3^2+a_2 a_3)}{12}}\, V_{nom},$$

$$B5 = \sqrt{\frac{2\sqrt{(4a_2^2+a_3^2+a_1^2+2a_2 a_3+2a_2 a_1-a_3 a_1)(a_3^2+a_1^2+a_3 a_1)}+(a_3^2+a_1^2+a_3 a_1)}{12}}\, V_{nom},$$

$$B6 = \sqrt{\frac{2\sqrt{(4a_3^2+a_1^2+a_2^2+2a_3 a_1+2a_3 a_2-a_1 a_2)(a_1^2+a_2^2+a_1 a_2)}+(a_1^2+a_2^2+a_1 a_2)}{12}}\, V_{nom}\,.$$

**6.** Procédé de détection selon la revendication 1, dans lequel les au moins une deuxième grandeur comprennent une deuxième grandeur qui est fonction d'une aire d'un triangle effectif (19) formé par les premières, deuxième et troisième tensions de phase dans la représentation de Fresnel.

7. Procédé de détection selon la revendication 6, dans lequel l'aire du triangle effectif est déterminée en utilisant la formule :

$$A = \frac{1}{2}(V_{1eff}V_{2eff}\sin\varphi_{12} + V_{2eff}V_{3eff}\sin\varphi_{23} + V_{3eff}V_{1eff}\sin\varphi_{31}),$$

où A est la deuxième grandeur, $V_{1eff}$, $V_{2eff}$ et $V_{3eff}$ sont respectivement les valeurs efficaces des première, deuxième et troisième tensions de phase, et $\varphi_{12}$ est un premier déphasage entre la première tension de phase et la deuxième tension de phase, $\varphi_{23}$ est un deuxième déphasage entre la deuxième tension de phase et la troisième tension de phase et $\varphi_{31}$ est un troisième déphasage entre la troisième tension de phase et la première tension de phase, le critère de référence étant alors que la deuxième grandeur est telle que :

$$A_{ref} - \varepsilon_1 \leq A \leq A_{ref} + \varepsilon_1$$

où $A_{ref}$ est une aire d'un triangle de référence et $\varepsilon_1$ est une première incertitude de mesure prédéterminée.

8. Procédé de détection selon la revendication 7, dans lequel, si les première, deuxième et troisième tensions de phase sont parfaitement équilibrées entre elles, l'aire du triangle de référence (18) prédéterminé est évaluée en utilisant la formule : $A_{ref} = \frac{3\sqrt{3}}{4}V_{nom}$ , où $A_{ref}$ est l'aire du triangle de référence et $V_{nom}$ est la valeur efficace nominale de tension de phase du réseau électrique.

9. Procédé de détection selon la revendication 1, dans lequel la au moins une deuxième grandeur comprend des deuxièmes grandeurs qui comportent une première tension composée $U_{12}$ représentative d'une différence entre la première tension de phase et la deuxième tension de phase, une deuxième tension composée $U_{23}$ représentative d'une différence entre la deuxième tension de phase et la troisième tension de phase et une troisième tension composée $U_{31}$ représentative d'une différence entre la troisième tension de phase et la première tension de phase, le critère de référence étant alors que :

$$\Phi_1 - \varepsilon_2 \leq U_{12} \leq \Phi_1 + \varepsilon_2$$

et

$$\Phi_2 - \varepsilon_2 \leq U_{23} \leq \Phi_2 + \varepsilon_2$$

et

$$\Phi_3 - \varepsilon_2 \leq U_{31} \leq \Phi_3 + \varepsilon_2,$$

où $\Phi_1$, $\Phi_2$ et $\Phi_3$ sont des valeurs de référence des premières, deuxième et troisième tensions composées mesurées en opération à un temps de référence $T_0$ précédent le temps T et $\varepsilon_2$ est une deuxième incertitude de mesure prédéterminée.

10. Procédé de détection selon la revendication 1, dans lequel les au moins une deuxième grandeur comprennent des deuxièmes grandeurs qui comportent un premier déphasage entre la première tension de phase ($V_1$) et la deuxième tension de phase ($V_2$), un deuxième déphasage entre la deuxième tension de phase ($V_2$) et la troisième tension de phase ($V_3$) et un troisième déphasage entre la troisième tension de phase ($V_3$) et la première tension de phase ($V_1$), le critère de référence prédéterminé étant alors que les premier, deuxième et troisième déphasages sont chacun non nuls et différents de 120 degrés.

11. Procédé de détection selon l'une des revendications précédentes, comprenant en outre l'étape de détecter une rupture de connexion du neutre lorsqu'il a été détecté que la deuxième grandeur vérifie le critère de référence prédéterminé un nombre de fois prédéterminé, correspondant à des vérifications consécutives espacées deux à deux dans le temps d'une durée prédéterminée.

12. Procédé de détection selon l'une des revendications précédentes, dans lequel, lorsqu'une rupture de connexion du neutre a été détectée, le procédé comprend en outre l'étape de générer un signal d'alarme pouvant être horodaté dans une mémoire (7B) de l'équipement électrique et/ou pouvant être transmis à un équipement externe audit équipement électrique.

13. Equipement électrique comprenant des capteurs de tension et une unité de traitement (7A) agencée pour mettre en oeuvre le procédé de détection selon l'une des revendications précédentes.

14. Equipement électrique selon la revendication 13, l'équipement électrique étant un compteur électrique (7).

15. Programme d'ordinateur comprenant des instructions qui conduisent l'équipement électrique selon l'une des revendications 13 ou 14 à exécuter les étapes du procédé de détection selon l'une des revendications 1 à 12.

16. Support d'enregistrement lisible par ordinateur, sur lequel est enregistré le programme d'ordinateur selon la revendication 15.

**Patentansprüche**

1. Verfahren zur Detektion einer Verbindungsunterbrechung eines Neutralleiters (6) eines dreiphasigen Stromnetzes, wobei das Detektionsverfahren zumindest teilweise in einer Verarbeitungseinheit (7A) eines mit dem Stromnetz (1) verbundenen, elektrischen Geräts (7) ausgeführt wird, und die folgenden, regelmäßig wiederholten Schritte umfasst, dass:

   - zu einem Zeitpunkt T eine erste Phasenspannung ($V_1$), gemessen zwischen einer ersten Phase (5A) des dreiphasigen Stromnetzes und dem Neutralleiter (6), eine zweite Phasenspannung ($V_2$), gemessen zwischen einer zweiten Phase (5B) und dem Neutralleiter (6), und eine dritte Phasenspannung ($V_3$), gemessen zwischen einer dritten Phase (5C) und dem Neutralleiter (6), erfasst werden, wobei die erste, die zweite und die dritte Phasenspannung von Spannungssensoren (7D) des elektrischen Geräts (7) gemessen werden;
   - eine erste Größe ausgewertet wird, die jeweils für die erste, die zweite und die dritte Phasenspannung ein Verhältnis zwischen einer maximalen Phasenspannung und einer minimalen Phasenspannung darstellt;

   **dadurch gekennzeichnet, dass** das Verfahren umfasst, dass:

   - wenn die erste Größe größer als ein vorbestimmter Schwellenwert ist, dann:

     ◦ aus der ersten, der zweiten und der dritten Phasenspannung zumindest eine zweite Größe ausgewertet wird, die einen aktuellen Ausgleich der ersten, zweiten und dritten Phasenspannungen untereinander darstellt;
     ◦ eine Verbindungsunterbrechung des Neutralleiters (6) zum Zeitpunkt T detektiert wird, wenn die zumindest eine zweite Größe ein vorbestimmtes Referenzkriterium erfüllt.

2. Detektionsverfahren nach Anspruch 1, wobei die zumindest eine zweite Größe eine zweite Größe umfasst, die eine Funktion von einer Summe von paarweisen Produkten von Effektivwerten der ersten, der zweiten und der dritten Phasenspannung ist.

3. Detektionsverfahren nach Anspruch 2, wobei für die zweite Größe G2 die folgende Gleichung gilt:

$$G2 = \sqrt{\tfrac{1}{3}(V_{1eff}V_{2eff} + V_{2eff}V_{3eff} + V_{3eff}V_{1eff})},$$

wobei $V_{1eff}$, $V_{2eff}$ und $V_{3eff}$ jeweils ein Effektivwert der ersten Phasenspannung ($V_1$), ein Effektivwert der zweiten Phasenspannung ($V_2$) und ein Effektivwert der dritten Phasenspannung ($V_3$) sind,

wobei für das vorbestimmte Referenzkriterium Folgendes gilt:

$$BorneInf \leq G2 \leq BorneSup.$$

4. Detektionsverfahren nach Anspruch 3, ferner die Schritte umfassend, dass:

- detektiert wird, ob:

$$V_{1eff} = V_{nom} \text{ und } V_{2eff} = V_{nom} \text{ und } V_{3eff} = V_{nom} \text{ ,}$$

wobei es sich bei $V_{nom}$ um einen nominalen Effektivwert der Phasenspannung des Stromnetzes handelt;
- wenn diese Bedingung erfüllt ist, **BorneInf** und **BorneSup** wie folgt definiert werden:

$$BorneInf = V_{nom}$$

und

$$BorneSup = \sqrt{\frac{2\sqrt{3}+1}{4}} V_{nom}.$$

5. Detektionsverfahren nach Anspruch 4, wobei wenn diese Bedingung nicht erfüllt ist, und wenn: $V_{1eff} = a_1 \cdot V_{nom}$ und $V_{2eff} = a_2 \cdot V_{nom}$ und $V_{3eff} = a_3 \cdot V_{nom}$, wobei, $a_1$, $a_2$ und $a_3$ reelle Koeffizienten sind wie beispielsweise $a_1 \neq a_2 \leq \neq a_3$, dann gilt:

$$BorneInf = min(B1, B2, B3, B4, B5, B6)$$

und

$$BorneSup = max(B1, B2, B3, B4, B5, B6),$$

wobei

$$B1 = \sqrt{\frac{\sqrt{(a_1^2+a_2^2+a_1 a_2)(a_1^2+a_3^2+a_1 a_3)}}{3}} V_{nom},$$

$$B2 = \sqrt{\frac{\sqrt{(a_2^2+a_3^2+a_2 a_3)(a_2^2+a_1^2+a_2 a_1)}}{3}} V_{nom},$$

$$B3 = \sqrt{\frac{\sqrt{(a_3^2+a_1^2+a_3 a_1)(a_3^2+a_2^2+a_3 a_2)}}{3}} V_{nom},$$

$$B4 = \sqrt{\frac{2\sqrt{(4a_1^2+a_2^2+a_3^2+2a_1 a_2+2a_1 a_3-a_2 a_3)(a_2^2+a_3^2+a_2 a_3)}+(a_2^2+a_3^2+a_2 a_3)}{12}} V_{nom},$$

$$B5 = \sqrt{\frac{2\sqrt{(4a_2^2+a_3^2+a_1^2+2a_2a_3+2a_2a_1-a_3a_1)(a_3^2+a_1^2+a_3a_1)}+(a_3^2+a_1^2+a_3a_1)}{12}}\, V_{nom},$$

$$B6 = \sqrt{\frac{2\sqrt{(4a_3^2+a_1^2+a_2^2+2a_3a_1+2a_3a_2-a_1a_2)(a_1^2+a_2^2+a_1a_2)}+(a_1^2+a_2^2+a_1a_2)}{12}}\, V_{nom}.$$

**6.** Detektionsverfahren nach Anspruch 1, wobei die zumindest eine zweite Größe eine zweite Größe umfasst, die eine Funktion von einem Flächeninhalt eines effektiven Dreiecks (19) ist, das durch die erste, die zweite und die dritte Phasenspannung in der Fresnel-Darstellung gebildet wird.

**7.** Detektionsverfahren nach Anspruch 6, wobei der Flächeninhalt des effektiven Dreiecks unter Verwendung der folgenden Formel bestimmt wird:

$$A = \frac{1}{2}\left(V_{1eff}V_{2eff}\sin\varphi_{12} + V_{2eff}V_{3eff}\sin\varphi_{23} + V_{3eff}V_{1eff}\sin\varphi_{31}\right),$$

wobei A die zweite Größe ist, $V_{1eff}$, $V_{2eff}$ und $V_{3eff}$ jeweils die Effektivwerte der ersten, der zweiten und der dritten Phasenspannung sind, und $\varphi_{12}$ eine erste Phasenverschiebung zwischen der ersten Phasenspannung und der zweiten Phasenspannung ist, $\varphi_{23}$ eine zweite Phasenverschiebung zwischen der zweiten Phasenspannung und der dritten Phasenspannung ist, und $\varphi_{31}$ eine dritte Phasenverschiebung zwischen der dritten Phasenspannung und der ersten Phasenspannung ist, wobei das Referenzkriterium darin besteht, dass die zweite Größe die folgende Bedingung erfüllt:

$$A_{ref} - \varepsilon_1 \le A \le A_{ref} + \varepsilon_1$$

wobei $A_{ref}$ ein Flächeninhalt eines Referenzdreiecks ist und $\varepsilon_1$ eine erste vorbestimmte Messunsicherheit ist.

**8.** Detektionsverfahren nach Anspruch 7, wobei, wenn die erste, die zweite und die dritte Phasenspannung untereinander vollkommen ausgeglichen sind, der Flächeninhalt des vorbestimmten Referenzdreiecks (18) unter Verwendung der folgenden Formel ausgewertet wird: $A_{ref} = \frac{3\sqrt{3}}{4} V_{nom}$ , wobei $A_{ref}$ der Flächeninhalt des Referenzdreiecks ist, und $V_{nom}$ der nominale Effektivwert der Phasenspannung des Stromnetzes ist.

**9.** Detektionsverfahren nach Anspruch 1, wobei die zumindest eine zweite Größe zwei Größen umfasst, welche enthalten: eine erste zusammengesetzte Spannung $U_{12}$, die eine Differenz zwischen der ersten Phasenspannung und der zweiten Phasenspannung darstellt, eine zweite zusammengesetzte Spannung $U_{23}$, die eine Differenz zwischen der zweiten Phasenspannung und der dritten Phasenspannung darstellt, und eine dritte zusammengesetzte Spannung $U_{31}$, die eine Differenz zwischen der dritten Phasenspannung und der ersten Phasenspannung darstellt, wobei das Referenzkriterium darin besteht, dass:

$$\Phi_1 - \varepsilon_2 \le U_{12} \le \Phi_1 + \varepsilon_2$$

und

$$\Phi_2 - \varepsilon_2 \le U_{23} \le \Phi_2 + \varepsilon_2$$

und

$$\Phi_3 - \varepsilon_2 \le U_{31} \le \Phi_3 + \varepsilon_2 ,$$

wobei $\Phi_1$, $\Phi_2$ und $\Phi_3$ jeweils Referenzwerte der ersten, der zweiten und der dritten zusammengesetzten Spannung sind, die während des Betriebs zu einem Referenzzeitpunkt $T_0$ gemessen wurden, der dem Zeitpunkt T vorangeht, und $\varepsilon_2$ eine zweite vorbestimmte Messunsicherheit ist.

10. Detektionsverfahren nach Anspruch 1, wobei die zumindest eine zweite Größe zweite Größen umfasst, welche enthalten: eine erste Phasenverschiebung zwischen der ersten Phasenspannung ($V_1$) und der zweiten Phasenspannung ($V_2$), eine zweite Phasenverschiebung zwischen der zweiten Phasenspannung ($V_2$) und der dritten Phasenspannung ($V_3$), und eine dritte Phasenverschiebung zwischen der dritten Phasenspannung ($V_3$) und der ersten Phasenspannung ($V_1$), wobei das vorbestimmte Referenzkriterium darin besteht, dass die erste, die zweite und die dritte Phasenverschiebung jeweils ungleich Null und ungleich 120 Grad sind.

11. Detektionsverfahren nach einem der vorhergehenden Ansprüche, ferner den Schritt umfassend, dass eine Verbindungsunterbrechung des Neutralleiters detektiert wird, wenn festgestellt wurde, dass die zweite Größe das vorbestimmte Referenzkriterium eine vorbestimmte Anzahl von Malen erfüllt, was aufeinanderfolgenden Überprüfungen entspricht, die paarweise um eine vorbestimmte Dauer zeitlich voneinander beabstandet sind.

12. Detektionsverfahren nach einem der vorhergehenden Ansprüche, wobei wenn eine Verbindungsunterbrechung des Neutralleiters detektiert wurde, das Verfahren ferner den Schritt umfasst, dass ein Alarmsignal erzeugt wird, das in einem Speicher (7B) des elektrischen Geräts mit einem Zeitstempel versehen werden kann und/oder an ein Gerät außerhalb des elektrischen Geräts übertragen werden kann.

13. Elektrisches Gerät umfassend Spannungssensoren und eine Verarbeitungseinheit (7A), die dazu angeordnet ist, das Detektionsverfahren nach einem der vorhergehenden Ansprüche auszuführen.

14. Elektrisches Gerät nach Anspruch 13, wobei es sich bei dem elektrischen Gerät um einen Stromzähler (7) handelt.

15. Computerprogramm, das Befehle umfasst, welche das elektrische Gerät nach einem der Ansprüche 13 oder 14 dazu veranlassen, die Schritte des Detektionsverfahrens nach einem der Ansprüche 1 bis 12 auszuführen.

16. Computerlesbares Speichermedium, auf welchem das Computerprogramm nach Anspruch 15 abgespeichert ist.

**Claims**

1. A method for detecting a break in connection of a neutral (6) of a three-phase electricity network, the detection method being implemented at least partially in a processing unit (7A) of an item of electrical equipment (7) connected to the electricity network (1), and comprising the steps, repeated regularly, of:

   - acquiring, at a time T, a first phase voltage ($V_1$) measured between a first phase (5A) of the three-phase electricity network and the neutral (6), a second phase voltage ($V_2$) measured between a second phase (5B) and the neutral (6), and a third phase voltage ($V_3$) measured between a third phase (5C) and the neutral (6), the first, second and third phase voltages being measured by voltage sensors (7D) of the item of electrical equipment (7);
   - evaluating a first quantity representative of a ratio between a maximum phase voltage and a minimum phase voltage from the first, second and third phase voltages;
   - the method being **characterized in that** if the first quantity is greater than a predetermined threshold:

      ◦ evaluating, based on the first, second and third phase voltages, at least a second quantity representative of a current balance between said first, second and third phase voltages;
      ◦ detecting a break in connection of the neutral (6) at the time T when the at least one second quantity satisfies a predetermined reference criterion.

2. A detection method according to claim 1, in which the at least one second quantity comprises a second quantity that is a function of a sum of pairwise products of root mean square values of the first, second and third phase voltages.

3. A detection method according to claim 2, in which said second quantity G2 is equal to:

$$G2 = \sqrt{\frac{1}{3}\left(V_{1eff}V_{2eff} + V_{2eff}V_{3eff} + V_{3eff}V_{1eff}\right)},$$

where $V_{1eff}$, $V_{2eff}$ and $V_{3eff}$ are respectively a root mean square value of the first phase voltage ($V_1$), a root mean square value of the second phase voltage ($V_2$) and a root mean square value of the third phase voltage ($V_3$), the predetermined reference criterion being that:

$$BorneInf \leq G2 \leq BorneSup.$$

4. A detection method according to claim 3, further comprising the steps of:

- detecting whether:

$$V_{1eff} = V_{nom} \;\; \text{and} \;\; V_{2eff} = V_{nom} \;\; \text{and} \;\; V_{3eff} = V_{nom},$$

where $V_{nom}$ is a nominal root mean square value of the phase voltage of the electricity network;

- if this condition is met, defining **BorneInf** and **BorneSup** as follows:

$$BorneInf = V_{nom}$$

and

$$BorneSup = \sqrt{\frac{2\sqrt{3}+1}{4}}\, V_{nom}.$$

5. A detection method according to claim 4, in which, if said condition is not met, and if:

$$V_{1eff} = a_1 \cdot V_{nom} \;\; \text{and} \;\; V_{2eff} = a_2 \cdot V_{nom} \;\; \text{and} \;\; V_{3eff} = a_3 \cdot V_{nom},$$

where $a_1$, $a_2$ and $a_3$ are real coefficients such that $a_1 \neq a_2 \neq a_3$, then:

$$BorneInf = min(B1, B2, B3, B4, B5, B6)$$

and

$$BornSup = max(B1, B2, B3, B4, B5, B6),$$

where

$$B1 = \sqrt{\frac{\sqrt{(a_1^2+a_2^2+a_1a_2)(a_1^2+a_3^2+a_1a_3)}}{3}}\, V_{nom},$$

$$B2 = \sqrt{\frac{\sqrt{(a_2^2+a_3^2+a_2a_3)(a_2^2+a_1^2+a_2a_1)}}{3}}\, V_{nom},$$

$$B3 = \sqrt{\frac{\sqrt{(a_3^2+a_1^2+a_3a_1)(a_3^2+a_2^2+a_3a_2)}}{3}} V_{nom},$$

$$B4 = \sqrt{\frac{2\sqrt{(4a_1^2+a_2^2+a_3^2+2a_1a_2+2a_1a_3-a_2a_3)(a_2^2+a_3^2+a_2a_3)}+(a_2^2+a_3^2+a_2a_3)}{12}} V_{nom},$$

$$B5 = \sqrt{\frac{2\sqrt{(4a_2^2+a_3^2+a_1^2+2a_2a_3+2a_2a_1-a_3a_1)(a_3^2+a_1^2+a_3a_1)}+(a_3^2+a_1^2+a_3a_1)}{12}} V_{nom},$$

$$B6 = \sqrt{\frac{2\sqrt{(4a_3^2+a_1^2+a_2^2+2a_3a_1+2a_3a_2-a_1a_2)(a_1^2+a_2^2+a_1a_2)}+(a_1^2+a_2^2+a_1a_2)}{12}} V_{nom}.$$

6. A detection method according to claim 1, in which the at least one second quantity comprises a second quantity that is a function of an area of an actual triangle (19) formed by the first, second and third phase voltages in the Fresnel diagram.

7. A detection method according to claim 6, in which the area of the actual triangle is determined by using the formula:

$$A = \frac{1}{2}(V_{1eff}V_{2eff}\sin\varphi_{12} + V_{2eff}V_{3eff}\sin\varphi_{23} + V_{3eff}V_{1eff}\sin\varphi_{31}),$$

where A is the second quantity, $V_{1eff}$, $V_{2eff}$ and $V_{3eff}$ are respectively the root mean square values of the first, second and third phase voltages, and $\varphi_{12}$ is a first phase shift between the first phase voltage and the second phase voltage, $\varphi_{23}$ is a second phase shift between the second phase voltage and the third phase voltage and $\varphi_{31}$ is a third phase shift between the third phase voltage and the first phase voltage, the reference criterion then being that the second quantity is such that:

$$A_{ref} - \varepsilon_1 \le A \le A_{ref} + \varepsilon_1$$

where $A_{ref}$ is an area of a reference triangle and $\varepsilon_1$ is a first predetermined measurement uncertainty.

8. A detection method according to claim 7, in which, if the first, second and third phase voltages are perfectly balanced, the area of the predetermined reference triangle (18) is evaluated by using the formula: $A_{ref} = \frac{3\sqrt{3}}{4}V_{nom}$, where $A_{ref}$ is the area of the reference triangle and $V_{nom}$ is the nominal root mean square value of the phase voltage of the electricity network.

9. A detection method according to claim 1, in which the at least one second quantity comprises second quantities which comprise a first line-to-line voltage $U_{12}$ representative of a difference between the first phase voltage and the second phase voltage, a second line-to-line voltage $U_{23}$ representative of a difference between the second phase voltage and the third phase voltage and a third line-to-line voltage $U_{31}$ representative of a difference between the third phase voltage and the first phase voltage, the reference criterion then being that:

$$\Phi_1 - \varepsilon_2 \le U_{12} \le \Phi_1 + \varepsilon_2$$

and

$$\Phi_2 - \varepsilon_2 \leq U_{23} \leq \Phi_2 + \varepsilon_2$$

and

$$\Phi_3 - \varepsilon_2 \leq U_{31} \leq \Phi_3 + \varepsilon_2,$$

where $\Phi_1$, $\Phi_2$ and $\Phi_3$ are reference values of the first, second and third line-to-line voltages measured during operation at a reference time $T_0$ preceding the time T and $\varepsilon_2$ is a second predetermined measurement uncertainty.

10. A detection method according to claim 1, in which the at least one second quantity comprises second quantities that comprise a first phase shift between the first phase voltage ($V_1$) and the second phase voltage ($V_2$), a second phase shift between the second phase voltage ($V_2$) and the third phase voltage ($V_3$) and a third phase shift between the third phase voltage ($V_3$) and the first phase voltage ($V_1$), the predetermined reference criterion then being that the first, second and third phase shifts are each non-zero and different to 120 degrees.

11. A detection method according to one of the preceding claims, further comprising the step of detecting a break in the neutral connection when it has been detected that the second quantity satisfies the predetermined reference criterion a predetermined number of times, corresponding to consecutive checks spaced apart two by two in time by a predetermined duration.

12. A detection method according to one of the preceding claims, in which, when a break in the neutral connection has been detected, the method further comprises the step of generating an alarm signal that can be timestamped in a memory (7B) of the electrical equipment and/or that can be transmitted to an external equipment to said electrical equipment.

13. Electrical equipment comprising voltage sensors and a processing unit (7A) arranged to implement the detection method according to one of the preceding claims.

14. Electrical equipment according to claim 13, the electrical equipment being an electricity meter (7).

15. A computer program comprising instructions that cause the electrical equipment according to one of claims 13 or 14 to perform the steps of the detection method according to one of claims 1 to 12.

16. A computer-readable storage medium on which the computer program according to claim 15 is stored.

**Fig. 1**

**Fig. 2**

Fig. 3

Fig. 4

Fig. 5

Rupture de
neutre

Fig. 6

**RÉFÉRENCES CITÉES DANS LA DESCRIPTION**

**Documents brevets cités dans la description**

- EP 3173800 A1